(19) Europäisches Patentamt
European Patent Office
Office européen des brevets

(11) EP 4 206 820 A1

(12) EUROPEAN PATENT APPLICATION

(43) Date of publication:
**05.07.2023 Bulletin 2023/27**

(21) Application number: **21306962.8**

(22) Date of filing: **30.12.2021**

(51) International Patent Classification (IPC):
***G03F 7/00*** *(2006.01)* ***G03F 7/027*** *(2006.01)*

(52) Cooperative Patent Classification (CPC):
**G03F 7/027; B33Y 70/00; G03F 7/0037; G03F 7/038**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ARKEMA FRANCE**
**92700 Colombes (FR)**

(72) Inventors:
- **REN, Kangtai**
  **EXTON, 19341 (US)**
- **JIANG, Hua**
  **EXTON, 19341 (US)**
- **KLANG, Jeffrey**
  **EXTON, 19341 (US)**

(74) Representative: **Arkema Patent**
**Arkema France**
**DRD-DPI**
**420, rue d'Estienne d'Orves**
**92705 Colombes Cedex (FR)**

# (54) HYBRID PHOTOCURABLE COMPOSITION

(57) An actinic radiation curable composition includes one or more oxetane functional compounds; b) one or more epoxy functional compounds; c) one or more (meth)acrylate functional compounds; and d) one or more photoinitiators. The oxetane functional compounds are present in the composition at from 55% to 90%, preferably from 60% to 90%, more preferably from 70% to 90%, by weight based on the total weight of the oxetane functional compounds and the epoxy functional compounds in the composition.

EP 4 206 820 A1

## Description

FIELD OF THE INVENTION

The invention relates to actinically cured materials, including those that are useful for additive manufacturing applications.

BACKGROUND OF THE INVENTION

Light curable materials are well-known and are useful for additive manufacturing applications, also referred to as three dimensional (3D) printing and including stereolithography (SL) printing processes. As LED (light emitting diode) lights have become less expensive and available in varying wavelengths in recent years, there is an interest in using them for the needed light radiation to effect the cure of 3D printed parts.

Acrylate-based radiation curable systems cure rapidly but suffer from shrinkage during cure. Hybrid systems, those that include a blend of acrylate-based and epoxy-based and/or oxetane-based radiation curable resins, were introduced to reduce the shrinkage. However, epoxy and oxetane materials cure much more slowly than the acrylate-based systems, although since they cure cationically, they will continue to cure even in the absence of light. Oxetane-based resins demonstrate even further reduced shrinkage than epoxy-based resins. However, oxetane resins are known to cure more slowly than epoxy-based resins when used on their own.

Previously, solid state lasers at a wavelength of 355 nm and a very high intensity, for example from 25mW (milliwatts) up to 2000mW and typically from 100mW to about 1500mW, were used to cure these epoxy, oxetane and acrylate hybrid systems. These lasers, at a shorter wavelength and high intensity, were sufficient to effect a rapid cure in these hybrid systems, in spite of the slower cure rates of the cationically cured epoxies and oxetane resins.

In recent years, LED (light-emitting diode) and LCD (liquid crystal) curing systems have become popular due to their improved environmental friendliness and reduced cost over traditional solid state lasers. However the LED and LCD curing systems usually provide longer wave lengths of 365nm, 385nm, 395nm, 405nm, 450nm, or 500 nm for example, and a lower intensity than the solid state lasers. Accordingly, the epoxy and oxetane resins in these hybrid systems cure even more slowly using the LED or LCD based UV curing systems. However, including oxetane-based resins in the hybrid systems is desirable, because they provide improved green strength and final properties and have the advantage of even lower shrinkage than the epoxy resins in the hybrid system that include acrylates.

In a typical hybrid resin, the cationic cure part of the composition (epoxy/oxetane) provides many benefits, but usually cures much more slowly than the acrylate part of the composition. Conventionally, up to 20 wt% oxetane in combination with epoxide, such as 20 wt% Uvicure S130 (Sartomer/Lambson) oxetane mixture with 80 wt% Uvicure S105 (Sartomer/Lambson) epoxy based on the weight of the cationic cure part of the composition, is recommended to accelerate cationic cure speed. This 20 wt% level of oxetane does improve the green strength to some extent, but the main part of green strength is contributed from the approximately 5 to 30 wt% of high functional acrylates in this hybrid system. Previously, in a conventional 3D printer equipped with a 355 nm solid state laser, the cure speed of this composition was good enough to build desirable green strength. However, when these stereolithography (SL) resins are used in a 3D printer equipped with LED's having 365 nm, 385 nm, 395 nm, or 405 nm wavelengths for monochromatic LCD lamps, it is very difficult to build parts with enough green strength, and the slow cure of the cationic part of the hybrid system (epoxy and oxetane) became a bottleneck for commercial success. This is due to the lower intensity light provided by the LED and LCD 3D printers. Therefore, these hybrid systems including epoxy and oxetane resins are presently significantly limited for use in a conventional hybrid system application in conjunction with LED or LCD printers.

Accordingly there is a need for activation radiation curable blends of acrylate, epoxy and oxetane resins that provide improved cure speed when exposed to longer wavelengths and lower intensity light.

J. Appl. Polym. Sci. 2020, 137, 48333 discloses a cationic/free-radical photopolymer, which consists of two epoxies and a tetrafunctional acrylate.

Polym. Int. 2016; 65: 1486-1492 discloses cationic photopolymerization of 3-benzyloxymethyl-3-ethyl-oxetane (MOX104) initiated by triphenylsulfonium hexafluoroantimonate under UV light.

J. Photopolym. Sct. Technol., page 119-124, Vol.13, No.1, 2000 discloses five oxetane monomers evaluated in a photo-cationic curing system.

J. Polym. Sci. Part A: Polym. Chem. 43: 3205-3220, 2005 discloses onium salt photoinitiated cationic ring-opening polymerizations of various 3,3-di-substituted oxetane monomers.

Polymer 42 (2001) 5531-5541 discloses interpenetrating polymer networks (IPNs) synthesized by light-induced cross-linking polymerization of a mixture of acrylate and epoxide monomers.

US 7,183,040 discloses a radiation curable composition comprising relative to the total weight of the composition (A) 0-29 weight % of a cationically curable component having a linking aliphatic ester group, (B) 10-85 weight % of an epoxy group containing component other than A, (C) 1-50 weight % of an oxetane group containing component, (D)

1-25 weight % of a multifunctional acrylate and a radical photoinitiator and a cationic photoinitiator.

US 7,696,260 discloses a composition comprising a cationically-polymerizable compound, an iodonium-based cationic initiator, a sensitizer for the cationic initiator and an antioxidant selected from the group consisting of phenol antioxidants, lactone antioxidants, and combinations of these antioxidants. The addition of this antioxidant to this composition contributes to the reduction of potential run-away reaction when it is exposed in-bulk to actinic radiation.

US 9,861,452 discloses liquid radiation curable resin compositions for additive manufacturing including from about 5 to about 30 weight % of an oxetane; a (meth)acrylate component; a cationic photoinitiator; a free-radical photoinitiator; and from about 50 to about 80 weight % of an epoxy, which further comprises a cycloaliphatic epoxy component, and an epoxy component having an aromatic glycidyl ether group, such that majority of the epoxy is the cycloaliphatic epoxy component. Also disclosed is a process for using the liquid radiation curable resins for additive manufacturing to create molds for dental aligners, and the three-dimensional molds made from the liquid radiation curable resins for additive manufacturing.

## SUMMARY OF THE INVENTION

Various oxetane compounds in conventional hybrid SL resins were evaluated. The results showed that up to 20 wt% of oxetane based on the total weight of cationically curable compounds in the resin provided some improvement in cure speed. Surprisingly, when the proportion of the slower curing oxetane portion of the cationically curable compounds was increased, the cure speed increased. This new discovery not only provides an effective approach to speed up cationic cure of hybrid systems, but also allows loading of more oxetane into formulations to match or exceed the printing performance of conventional hybrid SL systems, such as the faster cure speed, stronger green strength with desirable viscosity, improved mechanical properties and better thermodynamic properties. For example, up to 80 wt% of UviCure S130 mixture with 20 wt% of a cycloaliphatic epoxide, based on the total weight of cationically curable compounds, provided a maximum in the cure speed of a hybrid system. In addition, the introduction of a higher weight percentage of a dioxetane functional compound to the hybrid system provided an increased cure speed, and attained or exceeded the target mechanical properties of the cured part.

An actinic radiation curable composition is provided. The composition comprises, consists of, or consists essentially of the following components: a) one or more oxetane functional compounds; b) one or more epoxy functional c) one or more acrylate functional compounds; d) at least one photoinitiator; and optionally at least one additive. The composition comprises from 55% to 90%, preferably from 60% to 90%, more preferably from 70% to 90%, by weight of the one or more oxetane functional compounds based on the total weight of the one or more oxetane functional compounds and the one or more epoxy functional compounds in the composition. For example, a weight ratio of the total amount oxetane functional compounds to the total amount of epoxy-functional compounds may be from 90:10 to 55:45, or from 90:10 to 60:40, or from 85:15 to 75:25.

A method of preparing a 3D-printed article is also provided. The method comprises at least the following steps:

a) providing a first layer of any embodiment of the curable composition described herein onto a surface;
b) curing the first layer, at least partially, to provide a cured first layer;
c) providing an second layer of the curable composition onto the first cured layer;
d) curing the second layer, at least partially, to provide a cured second layer adhered to the cured first layer;
e) repeating steps c) and d) a desired number of times to build up the 3D-printed article.

## DETAILED DESCRIPTION OF THE INVENTION

An actinic radiation curable composition is provided. The composition comprises, consists of, or consists essentially of the following components: a) one or more oxetane functional compounds; b) one or more epoxy functional compounds; c) one or more acrylate functional compounds; d) one or more photoinitiators; and optionally at least one additive.

The actinic radiation curable composition comprises from 55% to 90%, preferably from 60% to 90%, more preferably from 70% to 90%, by weight of the one or more oxetane functional compounds based on the total weight of the one or more oxetane functional compounds and the one or more epoxy functional compounds in the composition. If the composition comprises a mixture of oxetane functional compounds and/or a mixture of epoxy functional compounds, the above weight percentages may be calculated using the total weight of the mixture of oxetane functional compounds and/or the total weight of the mixture of epoxy functional compounds.

As shown in the Examples, the inventors have found that contrary to an expected result of a slower curing composition, increasing the proportion of the oxetane component (which cures the slowest of the components in the composition) shows an increased cure rate, with a peak around 80% by weight of oxetane, based on the total weight of the oxetane and epoxy components in the composition.

a) Oxetane Functional Compound

The oxetane functional compounds may be monomers and/or oligomers. The total amount of oxetane functional compounds may be from 55% to 90%, preferably from 60% to 90%, more preferably from 70% to 90%, by weight based on the total weight of oxetane functional compounds and epoxy functional compounds in the composition.

For example, the actinic radiation curable composition may include at least 55%, at least 56%, at least 57%, at least 58%, at least 59%, at least 60%, at least 61%, at least 62%, at least 63%, at least 64%, at least 65%, at least 66%, at least 67%, at least 68%, at least 69%, at least 70%, at least 71%, at least 72%, at least 73%, at least 74%, at least 75%, at least 76%, at least 77%, at least 78%, at least 79% or at least 80%, by weight of oxetane functional compounds based on the total weight of oxetane functional compounds and epoxy functional compounds in the composition. According to other embodiments, the actinic radiation curable composition may include at most 90%, at most 89%, at most 88%, at most 87%, at most 86%, at most 85%, at most 84%, at most 83%, at most 82%, at most 81% or at most 80%, by weight of oxetane functional compounds based on the total weight of oxetane functional compounds and epoxy functional compounds in the composition. For all ranges or limits provided herein for a particular parameter (including weight percentage of a given constituent), the invention includes any range extending from any lower limit set forth herein to any upper limit.

The actinic radiation curable composition may comprise from 10% to 90%, preferably from 30% to 85%, more preferably from 50% to 80%, and most preferably from 55% to 80%, by weight of the one or more oxetane functional compounds based on the total weight of the curable composition. If the composition comprises a mixture of oxetane functional compounds, the above weight percentages may be calculated using the weight of the mixture of oxetane functional compounds.

Suitable illustrative oxetanes include oxetane itself and substituted derivatives thereof, provided the substituents do not interfere with the desired reaction/polymerization/curing of the oxetane. The substituent(s) may be, for example, alkyl groups, hydroxyalkyl groups, halo, haloalkyl groups, aryl groups, aralkyl groups and the like. The oxetane may be a mono-oxetane (a compound containing a single oxetane ring), a di-oxetane (a compound containing two oxetane rings), a tri-oxetane (a compound containing three oxetane rings), or an oxetane compound containing four or more oxetane rings. Examples of suitable oxetanes include, but are not limited to, oxetane, trimethylolpropane oxetane, 3-ethyl-3-hydroxymethyl oxetane, 1,4-bis[(3-ethyl-3-oxetanylmethoxy)methyl]benzene, 3-ethyl-3-phenoxymethyl oxetane, bis[(1-ethyl(3-oxetanyl))methyl] ether, 3,3-bis (chloromethyl oxetane), 3-ethyl-3-[(phenylmethoxy)methyl]-oxetane, bis[1-ethyl(3-oxetanyl)]methyl ether, 1,4-bis[(3-ethyl-3-oxetanylmethoxy)methyl]benzene, 4,4-bis(3-ethyl-3-oxetanyl)methoxymethyl]biphenyl, 3,3-bis (iodomethyl) oxetane, 3,3- bis(methoxymethyl) oxetane, 3,3-bis(phenoxymethyl) oxetane, 3-methyl-3-chloromethyl oxetane, 3,3-bis(acetoxymethyl) oxetane, 3,3-bis (fluoromethyl) oxetane, 3,3-bis(bromomethyl) oxetane, 3,3-dimethyl oxetane, 3,3'-[1,4-phenylenebis(methyleneoxymethylene)]bis[3-ethyloxetane], 3-ethyl-3-[[(2-ethylhexyl)oxy]methyl]oxetane, trimethylolpropane tris(3-ethyl-3-oxetanylmethyl)ether and the like and combinations thereof.

Examples of compounds having two or more oxetane rings in the compound which may be used in the present invention include: 3,7-bis(3-oxetanyl)-5-oxa-nonane, 3,3'-(1,3-(2-methylenyl)propanediylbis(oxymethylene))bis-(3-ethyloxetane), 1,4-bis[(3-ethyl-3-oxetanylmethoxy)methyl]benzene, 1,2-bis[(3-ethyl-3-oxetanylmethoxy)methyl]ethane, 1,3-bis[(3-ethyl-3-oxetanylmethoxy)methyl]propane, ethylene glycol bis(3-ethyl-3-oxetanylmethyl)ether, dicyclopentenyl bis(3-ethyl-3 oxetanylmethyl)ether, triethylene glycol bis(3-ethyl-3-oxetanylmethyl)ether, tetraethylene glycol bis(3-ethyl-3-oxetanylmethyl)ether, tricyclodecanediyldimethylene(3-ethyl-3-oxetanylmethyl)ether, trimethylolpropane tris(3-ethyl-3-oxetanylmethyl)ether, 1,4-bis(3-ethyl-3 oxetanylmethoxy)butane, 1,6-bis(3-ethyl-3-oxetanylmethoxy)hexane, pentaerythritol tris(3-ethyl-3-oxetanylmethyl)ether, pentaerythritol tetrakis(3-ethyl-3-oxetanylmethyl)ether, polyethylene glycol bis(3-ethyl-3-oxetanylmethyl)ether, dipentaerythritol hexakis(3-ethyl-3-oxetanylmethyl)ether, dipentaerythritol pentakis(3-ethyl-3-oxetanylmethyl)ether, dipentaerythritol tetrakis(3-ethyl-3-oxetanylmethyl)ether, caprolactone-modified dipentaerythritol hexakis(3-ethyl-3-oxetanylmethyl)ether, caprolactone-modified dipentaerythritol pentakis(3-ethyl-3-oxetanylmethyl)ether, ditrimethylolpropane tetrakis(3-ethyl-3-oxetanylmethyl)ether, EO-modified Bisphenol A bis(3-ethyl-3-oxetanylmethyl)ether, PO-modified Bisphenol A bis(3-ethyl-3-oxetanylmethyl)ether, EO-modified hydrogenated Bisphenol A bis(3-ethyl-3-oxetanylmethyl)ether, PO-modified hydrogenated Bisphenol A bis(3-ethyl-3-oxetanylmethyl)ether, EO-modified Bisphenol F (3-ethyl-3-oxetanylmethyl)ether, and the like and combinations thereof.

Additional examples of suitable oxetanes are described in the following patent documents, the disclosures of each of which are incorporated herein by reference in their entireties for all purposes: U.S. Pat. Publication No. 2010/0222512 A1, U.S. Pat. No. 3,835,003, U.S. Pat. No. 5,750,590, U.S. Pat. No. 5,674,922, U.S. Pat. No. 5,981,616, U.S. Pat. No. 6,469,108, U.S. Pat. No. 6,015,914, and U.S. Pat. No 8377623. Suitable oxetanes are available from commercial sources, such as the oxetanes sold by the Toagosei Corporation under the tradenames OXT-221, OXT-121, OXT-101, OXT-212, OXT-211, CHOX, OX-SC, and PNOX-1009.

Also suitable are oxetanes that also include one or more polymerizable sites of ethylenic unsaturation, such as may be supplied by a (meth)acrylate group, a (meth)acrylamide group, a vinyl group, an allyl group or the like. 3-ethyl-3-(methacryloyloxy)methyloxetane or (3-ethyloxetane-3-yl) methyl (meth)acrylate are specific examples of such a compound. These compounds are included in the calculation of the amount of oxetane in the curable composition.

The curable composition may also include a compound containing two or more different types of polymerizable heterocyclic rings. For example, the compound may contain one or more oxetane rings and one or more epoxy rings (3-[(oxiranylmethoxy)methyl] oxetane is an example of such a compound). These compounds are included as both epoxy and oxetane containing compounds in the calculation of the relative amount of the oxetane based on the total amount of the oxetane and epoxy functional compounds in the composition.

b) Epoxy Functional Compound

The epoxy functional compounds may be monomers and/or oligomers. The curable composition may include from 5% to 40%, preferably from 10% to 30%, more preferably from 10% to 20%, by weight of the one or more epoxy functional compounds based on the total weight of the curable composition. If the composition comprises a mixture of epoxy functional compounds, the above weight percentages may be calculated using the weight of the mixture of epoxy functional compounds.

Exemplary epoxy functional compounds suitable for use in the present invention include mono-epoxides, di-epoxides, and poly-epoxides (compounds containing three or more epoxy groups per molecule. Alicyclic polyglycidyl compounds and cycloaliphatic polyepoxides are two classes of suitable epoxy functional compounds. Such compounds contain two or more epoxide groups per molecule and may have a cycloaliphatic ring structure that contains the epoxide groups as side groups (pendant to the cycloaliphatic ring) or may have a structure where the epoxide groups are part of an alicyclic ring structure.

The epoxy functional compound may comprise, consist of or consist essentially of at least one epoxy ether. As used herein, the term "epoxy ether" means a compound comprising at least two epoxy groups and at least one ether bond (the ether bond being distinct from the cyclic ether bond in the epoxy groups). In particular, the epoxy ether may comprise at least two epoxy groups and at least two ether bonds (the ether bonds being distinct from the cyclic ether bonds in the epoxy groups).

The epoxy functional compound may comprise, consist of or consist essentially of at least one glycidyl ether. As used herein, the term "glycidyl ether" means a compound comprising at least two glycidyl ether groups. As used herein, the term "glycidyl ether group" means a group of the following formula (I):

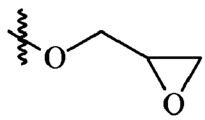

(I).

In one embodiment, the at least one epoxy compound may comprise, consist of or consist essentially of at least one compound bearing two glycidyl ether groups, also referred to as a diglycidyl ether. In another embodiment, the at least one epoxy a) may comprise, consist of or consist essentially of at least one compound bearing three glycidyl ether groups.

The at least one epoxy a) may comprise, consist of or consist essentially of at least one compound selected from an aromatic epoxy, an aliphatic epoxy and mixtures thereof.

The epoxy a) may comprise, consist of or consist essentially of at least one aromatic epoxy. As used herein, the term an "aromatic epoxy" means a compound comprising at least two epoxy groups connected to one another by an aromatic linker.

As used herein, the term "aromatic linker" means a linker comprising at least one aromatic ring, preferably at least two aromatic rings, more preferably 2 or 3 aromatic rings. Araliphatic linkers, i.e. linkers comprising both an aromatic moiety and a non-aromatic moiety, are encompassed by the term aromatic linker.

The aromatic epoxy may be an aromatic glycidyl ether. As used herein, the term "aromatic glycidyl ether" means a compound comprising at least two glycidyl ether groups connected to one another by an aromatic linker. Such a compound may be represented by the following formula (II):

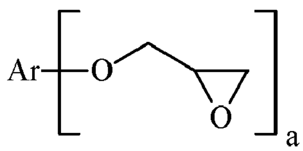

(II)

wherein Ar is an aromatic linker;
a is at least 2, preferably 2 to 10, more preferably 2 to 6.

The aromatic glycidyl ether may be a bisphenol-based glycidyl ether. As used herein, the term a "bisphenol-based glycidyl ether" means a compound comprising at least two glycidyl ether groups connected to one another by an aromatic linker containing a moiety derived from a bisphenol. Such a compound may be represented by the above formula (II) wherein a is 2 and Ar is represented by the following formula (III):

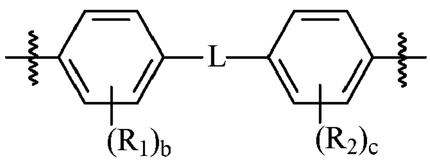
(III)

wherein L is a linker;
$R_1$ and $R_2$ are independently selected from alkyl, cycloalkyl, aryl and a halogen atom; b and c are independently 0 to 4.

In particular, L may be a linker selected from bond, $-CR_3R_4-$, -C(=O)-, -SO-, $-SO_2-$,$-C(=CCl_2)-$ and $-CR_5R_6-Ph-CR_7R_8-$;

wherein
$R_3$ and $R_4$ are independently selected from H, alkyl, cycloalkyl, aryl, haloalkyl and perfluoroalkyl, or $R_3$ and $R_4$, with the carbon atoms to which they are attached, may form a ring;
$R_5$, $R_6$, $R_7$ and $R_8$ are independently selected from H, alkyl, cycloalkyl, aryl, haloalkyl and perfluoroalkyl;
Ph is phenylene optionally substituted with one or more groups selected from alkyl, cycloalkyl, aryl and a halogen atom.

More particularly, Ar may be the residue of a bisphenol without the OH groups. A compound according to formula (III) wherein Ar is the residue of a bisphenol without the OH groups may be referred to as a bisphenol-based epoxy ether, preferably a bisphenol-based glycidyl ether. Examples of suitable bisphenols are bisphenol A, bisphenol AP, bisphenol AF, bisphenol B, bisphenol BP, bisphenol C, bisphenol C2, bisphenol F, bisphenol G, bisphenol M, bisphenol S, bisphenol P, bisphenol PH, bisphenol TMC, bisphenol-Z, dinitrobisphenol A, tetrabromobisphenol A and combinations thereof.

The epoxy functional compound may comprise, consist of or consist essentially of at least one aliphatic epoxy. As used herein, the term an "aliphatic epoxy" means a compound comprising at least two epoxy groups connected to one another by an aliphatic linker.

As used herein, the term "aliphatic linker" means a linker that does not comprise any aromatic rings. It may be a linear or branched, cyclic or acyclic, saturated or unsaturated, hydrocarbon linker. It may be substituted by one or more groups, for example selected from hydroxyl, halogen (Br, Cl, I, F), carbonyl, amine, carboxylic acid, -C(=O)-OR', -C(=O)-O-C(=O)-R', each R' being independently a C1-C6 alkyl. It may be interrupted one or more bonds selected from ether-(-O-), ester (-C(=O)-O- or -O-C(=O)-), amide (-C(=O)-NH- or-NH-C(=O)-), urethane (-NH-C(=O)-O- or -O-C(=O)-NH-), urea (-NH-C(=O)-NH-), carbonate (-O-C(=O)-O-), and mixtures thereof.

The at least one aliphatic epoxy may be selected from an aliphatic glycidyl ether, an epoxidized vegetable oil and combinations thereof.

The aliphatic epoxy may be an aliphatic glycidyl ether. As used herein, the term "aliphatic glycidyl ether" means a compound comprising at least two glycidyl ether groups connected to one another by an aliphatic linker. Such a compound may be represented by the following formula (IV):

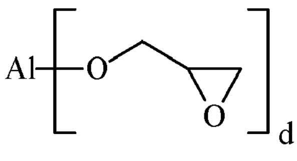
(IV)

wherein Al is an aliphatic linker;
d is at least 2, preferably 2 to 10, more preferably 2 to 6.

In particular, Al may be an alkylene optionally interrupted by one or more ether or ester bonds or Al may correspond to a partially or fully hydrogenated derivative of the linker of formula (III).

More particularly, Al may be the residue of a polyol $P_{OH}$ without the OH groups. Examples of suitable polyols $P_{OH}$ include ethylene glycol, 1,2- or 1,3-propylene glycol, 1,2-, 1,3- or 1,4-butylene glycol, 1,5-pentanediol, 1,6-hexanediol, 1,8-octanediol, 1,9-nonanediol, 1,10-decanediol, 1,12-dodecanediol, 2-methyl-1,3-propanediol, 2,2-diethyl-1,3-propanediol, 3-methyl-1,5-pentanediol, 3,3-dimethyl-1,5-pentanediol, neopentyl glycol, 2,4-diethyl-1,5-pentanediol, cyclohexanediol, cyclohexane-1,4-dimethanol, norbornene dimethanol, norbornane dimethanol, tricyclodecanediol, tricyclodecane dimethanol, hydrogenated bisphenol A, B, F or S, trimethylolmethane, trimethylolethane, trimethylolpropane, di(trimethylolpropane), triethylolpropane, pentaerythritol, di(pentaerythritol), glycerol, di-, tri- or tetraglycerol, polyglycerol, di-, tri- or tetraethylene glycol, di-, tri- or tetrapropylene glycol, di-, tri- or tetrabutylene glycol, a polyethylene glycol, a polypropylene glycol, a polytetramethylene glycol, a poly(ethylene glycol-co-propylene glycol), a sugar alcohol (i.e. erythritol, threitol, arabitol, xylitol, ribitol, mannitol, sorbitol, glactitol, fucitol, iditol), a dianhydrohexitol (i.e. isosorbide, isomannide, isoidide), a hydroxylated vegetable oil, tris(2-hydroxyethyl)isocyanurate, a polybutadiene polyol, a polyester polyol, a polyether polyol, a polyorganosiloxane polyol, a polycarbonate polyol as well as the alkoxylated (e.g., ethoxylated and/or propoxylated) derivatives thereof and the derivatives obtained by ring-opening polymerization of ε-caprolactone initiated with one of the aforementioned polyols.

The aliphatic epoxy compound may be an epoxidized vegetable oil.

As used herein the term "epoxidized vegetable oil" means an unsaturated vegetable oil wherein at least part of the carbon-carbon double bonds have been converted into epoxides. An unsaturated vegetable oil typically comprises one ore more unsaturated diglycerides and/or triglycerides. Unsaturated diglycerides and triglycerides may correspond to diesters and triesters of glycerol with one or more fatty acids wherein at least part of the fatty acids are unsaturated fatty acids. Fatty acids may be defined as monocarboxylic acids comprising 4 to 32 carbon atoms, in particular 8 to 30 carbon atoms, more particularly 10 to 28 carbon atoms. Unsaturated fatty acids correspond to fatty acids containing one or more carbon-carbon double bonds. Examples of unsaturated fatty acids are myristoleic acid, palmitoleic acid, sapienic acid, oleic acid, ricinoleic acid, elaidic acid, vaccenic acid, linoleic acid, linoelaidic acid, α-linolenic acid, arachidonic acid, eicosapentaenoic acid, erucic acid, docosahexaenoic acid and combinations thereof. Unsaturated vegetable oils may be extracted from a plant or tree, for example from seeds, fruits, flowers, bark, wood, stems or leaves of a plant or tree. Examples of suitable epoxidized vegetable oil include epoxidized soybean oil, epoxidized linseed oil, epoxidized castor oil, epoxidized corn oil, epoxidized cottonseed oil, epoxidized perilla oil, epoxidized safflower oil, epoxidized palm oil, epoxidized coconut oil, epoxidized rapeseed oil, epoxidized jatropha oil, epoxidized rubber seed oil, epoxidized tung oil, epoxidized tall oil, and combinations thereof.

Also suitable are linear or branched epoxidized polyenes, such as epoxidized polybutadienes and copolymers thereof, polyisoprenes, and copolymers thereof, for example.

Examples of compounds in which the epoxide groups form part of an alicyclic ring system include bis(2,3-epoxycyclopentyl)ether; 2,3-epoxycyclopentyl glycidyl ether, 1,2-bis(2,3-epoxycyclopentyloxy)ethane; bis(4-hydroxycyclohexyl)methane diglycidyl ether, 2,2-bis(4-hydroxycyclohexyl)propane diglycidyl ether; 3,4-epoxycyclohexylmethyl-3',4'-epoxycyclohexanecarboxylate; 3,4-epoxy-6-methyl-cyclohexylmethyl 3,4-epoxy-6-methylcyclohexanecarboxylate; di(3,4-epoxycyclohexylmethyl)hexanedioate; di(3,4-epoxy-6-methylcyclohexylmethyl)hexanedioate; ethylenebis(3,4-epoxycyclohexane-carboxylate, ethanediol di(3,4-epoxycyclohexylmethyl)ether; vinylcyclohexene dioxide; dicyclopentadiene diepoxide; and 2-(3,4-epoxycyclohexyl-5,5-spiro-3,4-epoxy-)cyclohexane-1,3-dioxane.

Suitable illustrative mono-epoxides include: glycidyl (meth)acrylate and (3,4-epoxycyclohexyl)methyl(meth)acrylate as well as other mono-epoxide compounds containing an epoxy group and a (meth)acrylate group.

Suitable illustrative di-epoxides include diglycidyl ethers of dialcohols and diglycidyl esters of di-acids such as: ethylene glycol diglycidyl ether, oligo- and polyethylene glycol diglycidyl ethers, propylene glycol diglycidyl ether, oligo- and polypropylene glycol diglycidyl ethers, butanediol diglycidyl ether, alkoxylated (e.g., ethoxylated, propoxylated) butanedioldiglycidyl ethers, neopentyl glycol diglycidyl ether, alkoxylated (e.g., ethoxylated, propoxylated) neopentyl glycol diglycidyl ethers, hexanediol diglycidyl ether, alkoxylated (e.g., ethoxylated, propoxylated) hexanediol diglycidyl ethers, cyclohexanedimethanol diglycidyl ether, alkoxylated (e.g., ethoxylated, propoxylated) cyclohexanedimethanol diglycidyl ethers, hydrogenated or nonhydrogenated bisphenol A diglycidyl ethers (BADGE), hydrogenated or nonhydrogenated bisphenol F diglycidyl ethers (BFDGE), diglycidyl ethers of alkoxylated (e.g., ethoxylated, propoxylated) bisphenols (such as bisphenol A or bisphenol F or hydrogenated derivatives thereof), diglycidyl esters of ortho-, iso- or terephthalic acid, diglycidyl esters of tetrahydrophthalic acid, and diglycidyl esters of hexahydrophthalic acid.

Suitable illustrative poly-epoxides include glycidyl ethers of compounds having three or more hydroxyl groups, such as hexane-2,4,6-triol; glycerol; 1,1,1-trimethylol propane; bistrimethylol propane; pentaerythritol; sorbitol; and alkoxylated (e.g., ethoxylated, propoxylated) derivatives thereof, epoxy novolac resins, and the like.

The curable composition, in certain embodiments, may comprise one or more polymerizable, heterocyclic moiety-containing compounds that comprise, in addition to one or more epoxy groups) one or more polymerizable sites of ethylenic unsaturation, such as may be supplied by a (meth)acrylate group, a (meth)acrylamide group, a vinyl group, an allyl group or the like. Glycidyl methacrylate, and glycidyl acrylate are specific examples of such a polymerizable, heterocyclic moiety-containing compounds. In the calculation of the relative amounts of oxetane and epoxy in the catatonically curable compounds in the composition, these compounds are considered to be epoxies. Examples of suitable epoxy (meth)acrylates include the reaction products of acrylic or methacrylic acid or mixtures thereof with glycidyl ethers or esters.

Other Cationically Curable Compounds

In addition to the oxetane functional compounds and the epoxy functional compounds in the hybrid composition, other cationically curable compounds may be included in the hybrid composition. Non-limiting examples of such compounds include compounds having free hydroxyl groups. The total weight of the cationically curable compounds, including epoxides, oxetanes and free hydroxyl components (such as hydroxyl groups from SpeedCure S130, OH from alcohol, polyol and OH from (meth)acrylates), should make 100% of the weight of the cationic system of the composition.

Even if other cationically curable compounds are present in the curable composition, the weight percentages of the one or more oxetane functional compounds mentioned herein (i.e. from 55% to 90%, or from 60% to 90%, or from 70% to 90%, by weight of the one or more oxetane functional compounds) are based on the total amount of the one or more oxetane functional compounds and the one or more epoxy functional compounds in the composition, not the entire weight of all of the cationically curable compounds.

Polyols may therefore be optionally included in the curable composition. As used herein, the term "polymeric polyol" means a polymer bearing two or more isocyanate-reactive hydroxyl groups per molecule. As used herein, the term "nonpolymeric polyol" means a nonpolymeric compound bearing two or more hydroxyl groups per molecule. In the context of the present invention, the term "polymer" means a compound containing five or more repeating units per molecule and the term "nonpolymeric compound" means a compound containing up to four repeating units per molecule (and thus both monomeric compounds and oligomeric compounds containing 2 to 4 repeating units per molecule). For instance, ethylene glycol, diethylene glycol, triethylene glycol and tetraethylene glycol are all examples of nonpolymeric polyols, whereas polyethylene glycol containing five or more oxyalkylene repeating units is an example of a polymeric polyol.

Preferably, the hydroxyl groups are primary and/or secondary hydroxyl groups. In the case where the polyol is a polymeric polyol, the hydroxyl groups, according to certain embodiments, may be positioned at terminal ends of the polymer. However, it is also possible for hydroxyl groups to be present along the backbone of the polymer or on side chains or groups pendant to the polymer backbone. The polymer portion of the polymeric polyol may be comprised of a plurality of repeating units such as oxyalkylene units, ester units, carbonate units, acrylic units, alkylene units or the like or combinations thereof.

According to certain embodiments of the invention, the polymeric polyol may be represented by the following structure:

$$HO\text{-}R_9\text{-}OH$$

where $R_9$ is a polyether (e.g., polyoxyalkylene), polycarbonate, polydiene, polyorganosiloxane or polyester chain or linker.

Particularly preferred polymeric polyols include polyether diols and polyester diols. Suitable polyether diols include, for example, polytetramethylene glycols (hydroxyl-functionalized polymers of tetrahydrofuran) and polyethylene glycols (hydroxyl-functionalized polymers of ethylene oxide). Suitable polyester diols include, for example, poly(caprolactones), poly(lactides), poly(alkylene glycol adipates) and poly(alkylene glycol succinates).

Other types of polymeric polyols potentially useful in the present invention include polycarbonate polyols, polyorganosiloxane polyols (e.g., polydimethylsiloxane diols or polyols), and polydiene polyols (e.g., polybutadiene diols or polyol, including fully or partially hydrogenated polydiene polyols).

The molecular weight of the polymeric polyol may be varied as may be needed or desired in order to achieve particular properties in the cured composition obtained by curing the curable composition. For example, the number average molecular weight of the polymeric polyol may be at least 300, at least 350, or at least 400 g/mol. In other embodiments, the polymeric polyol may have a number average molecular weight of 5000 g/mol or less, 4500 g/mol or less, or 4000 g/mol or less. For example, the polymeric polyol may have a number average molecular weight of 250 to 5000 g/mol, 300 to 4500 g/mol or 350 to 4000 g/mol.

According to certain embodiments of the invention, the polyol may be represented by the following structure:

$$HO\text{-}R_9\text{-}OH$$

wherein $R_9$ is a divalent nonpolymeric aliphatic moiety optionally additionally comprising one or more heteroatoms (such as O, N, S and/or halogen).

In certain aspects of the invention, the diol is or includes a nonpolymeric polyol which is a hydrogenated dimer fatty acid (sometimes also referred to as a "dimer diol"), e.g., a diol obtained by dimerizing one or more unsaturated fatty

acids such as oleic acid or linoleic acid and then hydrogenated to convert the carboxylic acid groups into hydroxyl groups. Pripol® 2033 (a product sold by Croda) is an example of a suitable commercially available hydrogenated dimer fatty acid.

Other types of suitable nonpolymeric polyols include, but are not limited to, C2-C12 aliphatic polyols, diols and oligomers thereof (containing up to four oxyalkylene repeating units). The aliphatic polyol or diol may be linear, branched or cyclic in structure, with the hydroxyl groups being both primary or both secondary or one or more of each type (one primary hydroxyl group and one secondary hydroxyl group, for example).

Examples of suitable C2-C12 aliphatic diols include, but are not limited to, ethylene glycol, 1,2-propylene glycol, 1,3-propanediol, 1,4-butanediol, 1,6-hexanediol, diethylene glycol, 2-methyl-1,3 propanediol, 3-methyl-1,5-pentanediol, 2,2-dimethyl-1,3-propanediol, 2,2,4-trimethyl 1,5-pentanediol, and 2-methyl-2-ethyl-1,3-propanediol, and oligomers thereof containing up to four oxyalkylene repeating units.

The optional at least one polyol, if present may be selected from ethylene glycol, propylene glycol, 1,3-propanediol, 1,2-, 1,3- or 1,4- butanediols, 2-methyl-1,3-propane diol (MPDiol), neopentyl glycol, alkoxylated derivatives of these, polyether diols, polyester diols, polycarbonate diols and combinations thereof.

The aliphatic diol (linear, branched or containing a ring structure) may be ethylene glycol, 1,2-propanedio, 1,3-propanediol, 1,4-butanediol, neopentyl glycol, 2-ethyl-1,3-hexanediol, 1,3-butanediol, 2-butyl-2-ethyl-1,3-propanediol, 2,4-diethyl-1,5-pentanediol and the like and short chain oligomers thereof (containing up to four oxyalkylene repeating units. Typically, the hydroxyl groups in such aliphatic diols are primary or secondary hydroxyl groups, which will react readily with the diisocyanates used to make the inherently reactive urethane acrylate oligomers.

The polyol may selected from ethylene glycol, propylene glycol, 1,3-propanediol, 1,2, 1,3 or 1,4 butanediols, 2-methyl-1,3-propane diol (MPDiol), neopentyl glycol, alkoxylated derivatives of these, polyether diols, polyester diols, or polysiloxane diols and combinations thereof.

The cationically curable compound may also be a cyclic ether compound, cyclic lactone compound, cyclic acetal compound, cyclic thioether compounds, spiro orthoester compounds or vinylether compound, for example.

c) (Meth)acrvlate Functional Compound

The curable composition may contain from 5% to 95%, preferably from 8% to 90%, more preferably from 10% to 80%, by weight of one or more (meth)acrylate functional compounds based on the total weight of the curable composition. If the composition comprises a mixture of (meth)acrylate functional compounds, the above weight percentage may be calculated using the weight of the mixture of (meth)acrylate functional compounds.

The curable composition may contain from 40% to 90%, from 45% to 85%, from 50% to 80%, or from 50% to 75% by weight of (meth)acrylate functional compounds based on the total weight of the curable composition. Alternatively, the curable composition may contain from 5% to 50%, from 8% to 45%, from 10% to 40% or from 10% to 30%, by weight of (meth)acrylate functional compounds based on the total weight of the curable composition. For example, the curable composition may contain at least 5%, 10%, 15%, 20%, 25%, 30%, 35%, 40%, 45%, 50%, 55%, 60%, 65%, 70%, 75%, 80%, 85% or 90% by weight of (meth)acrylate functional compounds based on the total weight of the curable composition. The curable composition may contain at most 95%, 90%, 85%, 80%, 75%, 70%, 65%, 60%, 55%, 50%, 45%, 40%, 35%, 30%, 25% or 20% by weight of (meth)acrylate functional compounds based on the total weight of the curable composition.

Polymerizable, ethylenically unsaturated compounds suitable for use in the present invention, other than the epoxy and oxetane containing compounds, include compounds containing at least one carbon-carbon double bond, in particular a carbon-carbon double bond capable of participating in a free radical reaction wherein at least one carbon of the carbon-carbon double bond becomes covalently bonded to an atom, in particular a carbon atom, in a second molecule. Such reactions may result in a polymerization or curing whereby the ethylenically unsaturated compound becomes part of a polymerized matrix or polymeric chain. In various embodiments of the invention, the additional ethylenically unsaturated compound(s) may contain one, two, three, four, five or more carbon-carbon double bonds per molecule. Combinations of multiple ethylenically unsaturated compounds containing different numbers of carbon-carbon double bonds may be utilized in the curable compositions of the present invention. The carbon-carbon double bond may be present as part of an $\alpha,\beta$-unsaturated carbonyl moiety, e.g., an $\alpha,\beta$-unsaturated ester moiety such as an acrylate functional group or a methacrylate functional group or an $\alpha,\beta$-unsaturated amide moiety such as an acrylamide functional group or a methacrylamide functional group . A carbon-carbon double bond may also be present in the additional ethylenically unsaturated compound in the form of a vinyl group $-CH=CH_2$ (such as an allyl group, $-CH_2-CH=CH_2$). Two or more different types of functional groups containing carbon-carbon double bonds may be present in the additional ethylenically unsaturated compound. For example, the ethylenically unsaturated compound may contain two or more functional groups selected from the group consisting of vinyl groups (including allyl groups), acrylate groups, methacrylate groups, acrylamide groups, methacrylamide groups and combinations thereof.

Polymerizable, ethylenically unsaturated compounds which are compounds suitable for use in the present invention include the following types of compounds (wherein "functional" refers to the number of (meth)acrylate functional

groups per molecule, e.g., monofunctional = one (meth)acrylate group per molecule, difunctional = two (meth)acrylate groups per molecule):

i) cyclic monofunctional (meth)acrylate compounds, such as isobornyl (meth)acrylate, cyclohexyl (meth)acrylate, 4-*tert*-butyl cyclohexyl (meth)acrylate and alkoxylated analogues thereof;

ii) linear or branched monofunctional (meth)acrylate compounds, such as isodecyl (meth)acrylate, ethoxyethoxyethyl (meth)acrylate, polyethylene mono(meth)acrylates, neopentyl glycol mono(meth)acrylate and alkoxylated analogues thereof, as well as caprolactone-based mono(meth)acrylates prepared by addition of one, two, three or more moles of caprolactone to a hydroxyalkyl (meth)acrylate such as hydroxyethyl (meth)acrylate ("caprolactone adducts of hydroxyalkyl (meth)acrylates");

iii) cyclic difunctional (meth)acrylate compounds, such as tricyclodecane dimethanol di(meth)acrylate, cyclohexane dimethanol di(meth)acrylate and alkoxylated analogues thereof;

iv) linear or branched difunctional (meth)acrylate compounds, such as polyethylene di(meth)acrylates, neopentyl glycol di(meth)acrylate and alkoxylated analogues thereof; and

v) trifunctional (meth)acrylate compounds, such as tris(2-hydroxyethyl) isocyanurate tri(meth)acrylate, trimethylolpropane tri(meth)acrylate and alkoxylated analogues thereof.

Illustrative examples of suitable polymerizable, ethylenically unsaturated compounds containing (meth)acrylate functionality include 1,2-, 1,3- or 1,4-butanediol di(meth)acrylate, 1,6-hexanediol di(meth)acrylate, alkoxylated 1,6-hexanediol di(meth)acrylate, alkoxylated aliphatic di(meth)acrylate, alkoxylated neopentyl glycol di(meth)acrylate, cyclohexane dimethanol di(meth)acrylate, diethylene glycol di(meth)acrylate, dipropylene glycol di(meth)acrylate, n-alkane (meth)acrylate, polyether di(meth)acrylates, ethoxylated bisphenol A di(meth)acrylate, ethylene glycol di(meth)acrylate, 1,2- or 1,3-propylene glycol di(meth)acrylate, neopentyl glycol di(meth)acrylate, polyester di(meth)acrylate, polyethylene glycol di(meth)acrylate, polypropylene glycol di(meth)acrylate, propoxylated neopentyl glycol diacrylate, tricyclodecane dimethanol di(meth)acrylate, triethylene glycol di(meth)acrylate, tetraethylene glycol di(meth)acrylate tripropylene glycol di(meth)acrylate, ditrimethylolpropane tetra(meth)acrylate, dipentaerythritol hexa(meth)acrylate, ethoxylated pentaerythritol tetra(meth)acrylate, dipentaerythritol penta(meth)acrylate, dipentaerythritol penta/hexa(meth)acrylate, penta(meth)acrylate ester, pentaerythritol tetra(meth)acrylate, ethoxylated trimethylolpropane tri(meth)acrylate, alkoxylated trimethylolpropane tri(meth)acrylate, propoxylated glyceryl tri(meth)acrylate, trimethylolpropane tri(meth)acrylate, pentaerythritol tri(meth)acrylate, propoxylated glyceryl tri(meth)acrylate, propoxylated trimethylolpropane tri(meth)acrylate, trimethylolpropane tri(meth)acrylate, tris (2-hydroxy ethyl) isocyanurate tri(meth)acrylate (also known as tris((meth)acryloxyethyl)isocyanurate), 2(2-ethoxyethoxy) ethyl (meth)acrylate, 2-phenoxyethyl (meth)acrylate, 3,3,5-trimethylcyclohexyl (meth)acrylate, alkoxylated lauryl (meth)acrylate, alkoxylated phenol (meth)acrylate, alkoxylated tetrahydrofurfuryl (meth)acrylate, caprolactone (meth)acrylate, (meth)acryloxyethyl di(caprolactone), cyclic trimethylolpropane formal (meth)acrylate, cycloaliphatic acrylate compound, dicyclopentadienyl (meth)acrylate, diethylene glycol methyl ether (meth)acrylate, ethoxylated (4) nonyl phenol (meth)acrylate, ethoxylated nonyl phenol (meth)acrylate, isobornyl (meth)acrylate, isodecyl (meth)acrylate, isooctyl (meth)acrylate, lauryl (meth)acrylate, methoxy polyethylene glycol (meth)acrylate, octyldecyl (meth)acrylate, stearyl (meth)acrylate, tetrahydrofurfuryl (meth)acrylate, tridecyl (meth)acrylate, and/or triethylene glycol ethyl ether (meth)acrylate, t-butyl cyclohexyl (meth)acrylate, alkyl (meth)acrylate, dicyclopentadiene di(meth)acrylate, alkoxylated nonylphenol (meth)acrylate, phenoxyethanol (meth)acrylate, octyl (meth)acrylate, decyl (meth)acrylate, dodecyl (meth)acrylate, tetradecyl (meth)acrylate, tridecyl (meth)acrylate, cetyl (meth)acrylate, hexadecyl (meth)acrylate, behenyl (meth)acrylate, diethylene glycol ethyl ether (meth)acrylate, diethylene glycol butyl ether (meth)acrylate, triethylene glycol methyl ether (meth)acrylate, 1,12-dodecanediol di(meth)acrylate, tricyclodecane methanol mono(meth)acrylate, glycerol carbonate (meth)acrylate and combinations thereof.

Suitable polyether (meth)acrylates include, but are not limited to, the condensation reaction products of acrylic or methacrylic acid or mixtures thereof with polyetherols which are polyether polyols. Suitable polyetherols can be linear or branched substances containing ether bonds and terminal hydroxyl groups. Polyetherols can be prepared by ring opening polymerization of cyclic ethers such as tetrahydrofuran or alkylene oxides with a starter molecule. Suitable starter molecules include water, hydroxyl functional materials, polyester polyols and amines.

One or more urethane diacrylates may be employed in certain embodiments of the invention. For example, the curable composition may comprise one or more urethane diacrylates comprising a difunctional aromatic urethane acrylate oligomer, a difunctional aliphatic urethane acrylate oligomer and combinations thereof. In certain embodiments, a difunctional aromatic urethane acrylate oligomer, such as that available from Sartomer USA, LLC (Exton, Pennsylvania) under the trade name CN9782, may be used as the one or more urethane diacrylates. In other embodiments, a difunctional

aliphatic urethane acrylate oligomer, such as that available from Sartomer USA, LLC under the trade name CN9023, may be used as the one or more urethane diacrylates. CN9782, CN9023, CN978, CN965, CN9031, CN8881, and CN8886, all available from Sartomer USA, LLC, may all be advantageously employed as urethane diacrylates in the compositions of the present invention.

Suitable acrylic (meth)acrylate oligomers (sometimes also referred to in the art as "acrylic oligomers") include oligomers which may be described as substances having an oligomeric acrylic backbone which is functionalized with one or (meth)acrylate groups (which may be at a terminus of the oligomer or pendant to the acrylic backbone). The acrylic backbone may be a homopolymer, random copolymer or block copolymer comprised of repeating units of acrylic compounds. The acrylic compounds may be any (meth)acrylate such as C1-C6 alkyl (meth)acrylates as well as functionalized (meth)acrylates such as (meth)acrylates bearing hydroxyl, carboxylic acid and/or epoxy groups. Acrylic (meth)acrylate oligomers may be prepared using any procedures known in the art such as oligomerizing compounds, at least a portion of which are functionalized with hydroxyl, carboxylic acid and/or epoxy groups (e.g., hydroxyalkyl(meth)acrylates, (meth)acrylic acid, glycidyl (meth)acrylate) to obtain a functionalized oligomer intermediate, which is then reacted with one or more (meth)acrylate-containing reactants to introduce the desired (meth)acrylate functional groups. Suitable acrylic (meth)acrylate oligomers are commercially available from Sartomer USA, LLC under products designated as CN820, CN821, CN822 and CN823, for example.

Suitable free (meth)acrylate oligomers include, for example, polyester (meth)acrylates, epoxy (meth)acrylates, polyether (meth)acrylates, polyurethane (meth)acrylates, acrylic (meth)acrylate oligomers, epoxy-functional (meth)acrylate oligomers and combinations thereof.

According to certain embodiments, the curable composition is comprised of one or more polymerizable, ethylenically unsaturated compounds that contain one or more hydroxyl groups per molecule. Examples of such hydroxyl group-containing ethylenically unsaturated compounds include, but are not limited to, caprolactone adducts of hydroxyalkyl (meth)acrylates (compounds corresponding to the general formula $H_2C=C(R)-C(=O)-O-R^1-(OC(=O)-[(CH_2)_5]_nOH$, wherein R = H, $CH_3$, $R^1$ = $C_2$-$C_4$ alkylene, such as ethylene, propylene, butylene, and n = 1-10, e.g., acryloxyethyl di(caprolactone)), hydroxyalkyl (meth)acrylates, alkoxylated (e.g., ethoxylated and/or propoxylated) hydroxyalkyl (meth)acrylates (including mono(meth)acrylates of ethylene glycol and propylene glycol oligomers and polymers), and the like.

The amount of polymerizable, ethylenically unsaturated, especially acrylate compounds which may be present in the curable compositions of the present invention is not believed to be particularly critical and may be readily varied as may be desired depending upon parameters such as, for example, the identity or identities of the polymerizable, ethylenically unsaturated compound(s), the nature of the other components of the curable composition, and the desired properties or attributes of the curable composition and the cured composition obtained therefrom. For example, and without limitation, the curable composition may be comprised of from 5% to 90% by weight, in total, of polymerizable, ethylenically unsaturated compound.

## d) Photoinitiator

In certain embodiments of the invention, the curable compositions described herein include one or more photoinitiators and are curable with radiant energy. A photoinitiator is a compound that chemically changes due to the action of light (or the synergy between the action of light and the electronic excitation of a sensitizing dye) to produce at least one of a radical, an acid, and a base, whereupon the radical, acid, and/or base effectuates a polymerization reaction in one or more of the polymerizable substances present in the corresponding composition. A photoinitiator which is capable (when subjected to light of an appropriate wavelength and/or intensity) of effectuating polymerization of the free-radically curable constituent is a free- radical photoinitiator. A photoinitiator which is capable (when subjected to light of an appropriate wavelength and/or intensity) of effectuating polymerization of the cationically curable constituent is a cationic photoinitiator. A particular photoinitiator may serve as both a free-radical photoinitiator and a cationic photoinitiator, although typically at least two different photoinitiators are employed for this purpose.

In embodiments, the present composition may include a free-radical photoinitiator. Typically, free radical photoinitiators include those which form radicals by either a Norrish Type I or P mechanism. Such photoinitiators include those which form radicals by cleavage, known as "Norrish Type I", and those that form radicals by hydrogen abstraction, known as "Norrish type II’. The Norrish type II photoinitiators require a hydrogen donor, which serves as the free radical source. As the initiation is based on a bimolecular reaction, the Norrish type II photoinitiators are generally slower than Norrish type I photoinitiators which are based on the unimolecular formation of radicals. On the other hand, Norrish type II photoinitiators possess better optical absorption properties in the near-UV spectroscopic region. Photolysis of aromatic ketones, such as benzophenone, thioxanthones, benzil, and quinones, in the presence of hydrogen donors, such as alcohols, amines, or thiols leads to the formation of a radical produced from the carbonyl compound (ketyl-type radical) and another radical derived from the hydrogen donor. The photopolymerization of vinyl compounds is usually initiated by the radicals produced from the hydrogen donor. The ketyl radicals are usually not reactive toward vinyl compounds

because of the steric hindrance and the delocalization of an unpaired electron.

For example, the photoinitiator(s) may comprise at least one of α-hydroxyketones, phenylglyoxylates, benzyldimethylketals, α-aminoketones, mono-acyl phosphines, bis-acyl phosphines, phosphine oxides, and combinations thereof (such as blends of alpha hydroxyl ketone or acyl phosphine oxide). In particular embodiments, the one or more photoinitiators may be 1-hydroxy-cyclohexyl-phenyl-ketone and/or 2-hydroxy-2-methyl-1-phenyl-1-propanone. In other embodiments, the one or more photoinitiators are or include a phosphine oxide, in particular bis(2,4-6-trimethylbenzoyl)phenyl phosphine oxide, (2,4,6-trimethylbenzoyl)phenylethoxy phosphine oxide, tris(2,4,6-trimethylbenzoyl)phosphine oxide and liquid mixtures thereof.

Suitable photoinitiators include, but are not limited to, 2-methylanthraquinone, 2-ethylanthraquinone, 2-chloroanthraquinone, 2-benzyanthraquinone, 2-t-butylanthraquinone, 1,2-benzo-9,10-anthraquinone, benzyl, benzoin, benzoin methyl ether, benzoin ethyl ether, benzoin isopropyl ether, alpha-methylbenzoin, alpha-phenylbenzoin, Michler's ketone, benzophenone, 4,4'-bis-(diethylamino) benzophenone, acetophenone, 2,2-diethyloxyacetophenone, diethyloxyacetophenone, 2-isopropylthioxanthone, thioxanthone, diethyl thioxanthone, 1,5-acetonaphthylene, ethyl-p-dimethylaminobenzoate, benzil ketone, α-hydroxy keto, 2,4,6-trimethylbenzoyldiphenyl phosphine oxide, benzyl dimethyl ketal, benzil ketal (2,2-dimethoxy-1,2-diphenylethanone), 1-hydroxycylclohexyl phenyl ketone, 2-methyl-1-[4-(methylthio)phenyl]-2-morpholinopropanone-1, 2-hydroxy-2-methyl-1-phenyl-propanone, oligomeric α-hydroxy ketone, phenylbis(2,4,6-trimethylbenzoyl)phosphine oxide, ethyl-4-dimethylamino benzoate, ethyl(2,4,6-trimethylbenzoyl)phenyl phosphinate, anisoin, anthraquinone, anthraquinone-2-sulfonic acid, sodium salt monohydrate, (benzene) tricarbonylchromium, benzil, benzoin isobutyl ether, benzophenone/1-hydroxycyclohexyl phenyl ketone, 50/50 blend, 3,3',4,4'-benzophenonetetracarboxylic dianhydride, 4-benzoylbiphenyl, 2-benzyl-2-(dimethylamino)-4'-morpholinobutyrophenone, 4,4'-bis(diethylamino)benzophenone,

4,4'-bis(dimethylamino)benzophenone, camphorquinone, 2-chlorothioxanthen-9-one, dibenzosuberenone, 4,4'-dihydroxybenzophenone, 2,2-dimethoxy-2-phenylacetophenone, 4-(dimethylamino)benzophenone, 4,4'-dimethylbenzil, 2,5-dimethylbenzophenone,

3,4-dimethylbenzophenone, diphenyl(2,4,6-trimethylbenzoyl)phosphine oxide /2-hydroxy-2-methylpropiophenone, 50/50 blend, 4'-ethoxyacetophenone, 2,4,6-trimethylbenzoyldiphenylphophine oxide, phenyl bis(2,4,6-trimethyl benzoyl)phosphine oxide, ferrocene, 3'-hydroxyacetophenone, 4'-hydroxyacetophenone, 3-hydroxybenzophenone, 4-hydroxybenzophenone, 1-hydroxycyclohexyl phenyl ketone, 2-hydroxy-2-methylpropiophenone, 2-methylbenzophenone, 3-methylbenzophenone, methybenzoylformate, 2-methyl-4'-(methylthio)-2-morpholinopropiophenone, phenanthrenequinone, 4'-phenoxyacetophenone, (cumene)cyclopentadienyl iron(ii) hexafluorophosphate, 9,10-diethoxy and 9,10-dibutoxyanthracene, 2-ethyl-9,10-dimethoxyanthracene, thioxanthen-9-one and combinations thereof.

The photocurable composition of the present invention may include at least one cationic photoinitiator, preferably in an amount from about 0.2-10% by weight, based on the total weight of the photocurable composition. The cationic photoinitiator may be chosen from those commonly used to initiate cationic photopolymerization. Examples include onium salts with anions of weak nucleophilicity, e.g., halonium salts, iodosyl salts, sulfonium salts, sulfoxonium salts, or diazonium salts. Metallocene salts are also suitable as photoinitiators. Onium salt and metallocene salt photoinitiators are also suitable as are aromatic diazonium salts, aromatic sulfonium salts, aromatic iodonium salts, metallocene based compounds, aromatic phosphonium salts, acylsulfonium salts, and any combination thereof. In another embodiment, the cation is a polymeric sulfonium salt. In another embodiment, the cationic photoinitiator may be at least one of tri aryl sulfonium salts, diaryliodonium salts, and metallocene based compounds, and any combination thereof. Onium salts, e.g., iodonium salts and sulfonium salts, and ferrocenium salts, have the advantage that they are generally more thermally stable. In a particular embodiment, the cationic photoinitiator has an anion including at least one of $BF_4$-, $AsF_6$-, $SbF_6$-, $PF_6$-[$B(CF_3)_4$]-, $C_6F_5)_4$, B[$C_6H_3$-3,5$(CF_3)_2]_4$-, B($C_6H_4$CF3)4-, B($C_6H_3F_2$)4-, B[$C_6$F4-4(CF3)$]_4$-, Ga$(C_6F_5)_4$-, [$(C_6F_5)_3$B-$C_3H_3N_2$-B$(C_6F_5)_3$[-,$(C_6F_5)_3$B-$NH_2$-B$(C_6F_5)_3$], tetrakis(3,5-difluoro-4-alkyloxyphenyl)borate, tetrakis(2,3,5,6-tetrafluoro-4- alkyloxyphenyl)borate, perfluoroalkyl sulfonates, tris[(perfluoroalkyl)sulfonyl]methides, bis [(perfluoroalkyl) sulfonyl]imides, perfluoroalkylphosphates, tris(perfluoroalkyl)trifluorophosphates, bis(perfluoroalkyl)tetrafluorophosphates, tris(pentafluoroethyl)trifluorophosphates, and ($CH_6B_{11}Br_6$)-, ($CH_6B_{11}Br_6$)-, or other halogenated carborane anions.

Examples of commercial cationic photoinitiators include Cyracure® UVI-6974 and UVI-6976 (which are a mixture of S,S,S,S'-Tetraphenylthiobis(4,1-phenylene)disulfonium dihexafluoroantimonate and diphenyl(4-phenylthiophenyl)sulfonium hexafluoroantimonate), Cyracure® UVI-6970, UVI-6960, UVI-6990 (DOW Corp.), CD1010, CD-1011, CD-1012 (Sartomer Corp.), Adekaoptomer SP150, SP-151, SP-170, SP-171 (Asahi Denka Kogyo Co., Ltd.), Irgacure® 261, CI-2481, CI-2624, CI-2639, CI2064 (Nippon Soda Co, Ltd.), and DTS-102, DTS-103, NAT-103, NDS-103, TPS-103, MDS-103, MPI-103, BBI-103 (Midori Chemical Co, Ltd.). Most preferred are UVI-6974, CD-1010, UVI-6976, Adekaoptomer SP-170, SP-171, CD-1012, and MPI-103 and KI78 (hexafluoroantimony sulfonium salt from Asahi Denka). Also

suitable is a mixture of S,S,S,S'-Tetraphenylthiobis(4,1-phenylene)disulfonium dihexafluoroantimonate and diphenyl(4-phenylthiophenyl)sulfonium hexafluoroantimonate. The cationic photoinitiators can be used either individually or in combination of two or more. The cationic photoinitiator can comprise a $^-PF6$ salt. Examples of known cationic photoinitiators include 4-[4-(3- chlorobenzoyl)phenylthio]phenylbis(4-fluorophenyl)sulfonium hexafluoroantimonate, 4-[4-(3-chlorobenzoyl)phenylthio]phenylbis(4-fluorophenyl)sulfonium tetrakis(pentafluorophenyl)borate, 4-[4-(3-chlorobenzoyl)phenylthio]phenylbis(4-fluorophenyl)sulfonium tetrakis(3,5-difluoro-4- methyloxyphenyl)borate, 4-[4-(3-chlorobenzoyl)phenylthio]phenylbis(4-fluorophenyl)sulfonium tetrakis(2,3,5,6-tetrafluoro-4-methyloxyphenyl)borate, tris(4-(4-acetylphenyl)thiophenyl)sulfonium tetrakis(pentafluorophenyl)borate (Irgacure® PAG 290 from BASF), tris(4-(4-acetylphenyl)thiophenyl)sulfonium tris[(trifluoromethyl)sulfonyl]methide (Irgacure® GSID 26-1 from BASF), tris(4-(4-acetylphenyl)thiophenyl)sulfonium hexafluorophosphate (Irgacure® 270 from BASF), and HS-1 available from San-Apro Ltd.

Known cationic photoinitiators include, either alone or in a mixture: bis[4-diphenylsulfoniumphenyl] sulfide bishexafluoroantimonate; thiophenoxyphenylsulfonium hexafluoroantimonate (available as Chivacure 1176 from Chitec), tris(4-(4-acetylphenyl)thiophenyl)sulfonium tetrakis(pentafluorophenyl)borate (Irgacure® PAG 290 from BASF), tris(4-(4-acetylphenyl)thiophenyl)sulfonium tris[(trifluoromethyl)sulfonyl]methide (Irgacure® GSID 26-1 from BASF), and tris(4-(4-acetylphenyl)thiophenyl)sulfonium hexafluorophosphate (Irgacure® 270 from BASF), [4-(1-methylethyl)phenyl](4-methylphenyl) iodonium tetrakis(pentafluorophenyl)borate (available as Rhodorsil 2074 from Rhodia), (4- octyloxyphenyl) phenyliodonium hexafluoroantimonate (available as OPPI FP 5386 from Hampford), 4-[4-(2-chlorobenzoyl)phenylthio]phenylbis(4-fluorophenyl)sulfonium hexafluoroantimonate (as SP-172 from Adeka), SP-300 from Adeka, and aromatic sulfonium salts with anions of $(PF_{6-m}(C_nF_{2n+1})_m)^-$ where m is an integer from 1 to 5, and n is an integer from 1 to 4 (available as CPI-200K or CPI-200S, which are monovalent sulfonium salts from San-Apro Ltd., TK-1 available from San-Apro Ltd., or HS-1 available from San-Apro Ltd.).

In an embodiment the composition may include an aromatic triaryl sulfonium salt cationic photoinitiator. An example of a triaryl sulfonium tetrakis(pentafluorophenyl)borate cationic photoinitiator is tris(4-(4-acetylphenyl)thiophenyl)sulfonium tetrakis(pentafluorophenyl)borate. Tris(4-(4-acetylphenyl)thiophenyl)sulfonium tetrakis(pentafluorophenyl)borate is known commercially as IRGACURE® PAG-290, and is available from Ciba/BASF. The cationic photoinitiator may be an aromatic triaryl sulfonium salt that possesses an anion represented by $SbF_6^-$, $PF_6^-$, $BF_4^-$, $(CF_3CF_2)_3PF_3^-$, $(C_6F_5)_4B^-$, $((CF_3)_2C_6H_3)_4B^-$, $(C_6F_5)_4Ga^-$, $((CF_3)_2C_6H_3)_4Ga^-$ trifluoromethanesulfonate, nonafluorobutanesulfonate, methanesulfonate, butanesulfonate, benzenesulfonate, or p-toluenesulfonate. Another cationic photoinitiator is an aromatic triaryl sulfonium cationic photoinitiator has an anion that is a fluoroalkyl -substituted fluorophosphate. Commercial examples of an aromatic triaryl sulfonium cationic photoinitiator having a fluoroalkyl-substituted fluorophosphate anion is the CPI-200 series (for example CPI-200K® or CPI-210S®) or 300 series, available from San-Apro Limited.

The amount of photoinitiator is not considered to be critical, but may be varied as may be appropriate depending upon the photoinitiator(s) selected, the amounts and types of ethylenically unsaturated compounds present in the curable composition, the radiation source and the radiation conditions used, among other factors. Typically, however, the amount of photoinitiator may be from 0.05% to 5% by weight, or from about 0.2-10% by weight, based on the total weight of the curable composition.

In certain embodiments of the invention, the curable compositions described herein do not include any initiator and are curable (at least in part) with electron beam energy. In other embodiments, the curable compositions described herein include at least one free radical initiator that decomposes when heated or in the presence of an accelerator and are curable chemically (i.e., without having to expose the curable composition to radiation). The at least one free radical initiator that decomposes when heated or in the presence of an accelerator may, for example, comprise a peroxide or azo compound. Suitable peroxides for this purpose may include any compound, in particular any organic compound, that contains at least one peroxy (-O-O-) moiety, such as, for example, dialkyl, diaryl and aryl/alkyl peroxides, hydroperoxides, percarbonates, peresters, peracids, acyl peroxides and the like. The at least one accelerator may comprise, for example, at least one tertiary amine and/or one or more other reducing agents based on M-containing salts (such as, for example, carboxylate salts of transition metals such as iron, cobalt, manganese, vanadium and the like and combinations thereof). The accelerator(s) may be selected so as to promote the decomposition of the free radical initiator at room or ambient temperature to generate active free radical species, such that curing of the curable composition is achieved without having to heat or bake the curable composition. In other embodiments, no accelerator is present and the curable composition is heated to a temperature effective to cause decomposition of the free radical initiator and to generate free radical species which initiate curing of the polymerizable compound(s) present in the curable composition.

## Thermal Initiators

In some embodiments, the curable compositions described herein further include, in addition to the photoinitiator, at least one free radical initiator that decomposes when heated and thus also cures the composition chemically (i.e., in addition to exposing the curable composition to radiation). The at least one free radical initiator may be referred to herein as a thermal initiator. The thermal initiator that decomposes when heated or in the presence of an accelerator may, for

example, comprise a peroxide or azo compound. Suitable peroxides for this purpose may include any compound, in particular any organic compound, that contains at least one peroxy (-O-O-) moiety, such as, for example, dialkyl, diaryl and aryl/alkyl peroxides, hydroperoxides, percarbonates, peresters, peracids, acyl peroxides and the like. The at least one accelerator may comprise, for example, at least one tertiary amine and/or one or more other reducing agents based on M-containing salts (such as, for example, carboxylate salts of transition M-containing salts such as iron, cobalt, manganese, vanadium and the like and combinations thereof). The accelerator(s) may be selected so as to promote the decomposition of the thermal initiator at room or ambient temperature to generate active free radical species, such that curing of the curable composition is achieved without having to heat or bake the curable composition. In other embodiments, no accelerator is present and the curable composition is heated to a temperature effective to cause decomposition of the thermal initiator and to generate free radical species which initiate curing of the polymerizable compound(s) present in the curable composition. Without wishing to be bound by theory, according to some embodiments, the exotherm provided by the photo-induced polymerization provides enough heat to decompose such chemical (thermal) free radical initiators.

The concentration of thermal initiator in the actinically curable compositions of the present disclosure may be varied as desired depending upon the particular compound(s) selected, the type or types of polymerizable compound(s) present in the actinically curable composition, the curing conditions utilized, and the rate of curing desired, among other possible factors. Typically, however, the actinically-curable composition may further include from 0.05% to 5%, preferably 0.1% to 2% by weight of the thermal initiator, based on the total weight of the curable composition, excluding reinforcement. According to some embodiments, typical concentrations of the thermal initiator may be up to about 15% by weight based on the total weight of the curable composition, excluding the reinforcement. For example, the actinic radiation-curable composition may comprise from 0.1 to 10% by weight, in total, of thermal initiator, based on the total weight of the curable composition, excluding any reinforcement.

Thus, in various embodiments of the present invention, the curable compositions described herein are curable by techniques selected from the group consisting of radiation curing (UV radiation or electron beam curing), electron beam curing, chemical curing (using a free radical initiator that decomposes when heated or in the presence of an accelerator, e.g., peroxide curing), heat curing or combinations thereof.

## Fillers

The curable composition may include at least one filler, such as at least one opaque filler, which is insoluble in the other components of the light-curable composition. In particular, such filler does not dissolve in the curable composition. Further, it is preferred that the least one filler is insoluble in the solid resin matrix formed by curing the curable resin composition. The use of one or more fillers which are insoluble in the cured resin matrix makes possible the production of composite materials from the curable compositions of the present invention.

The filler or fillers may be of any suitable shape or form. For example, the filler may take the form of powder, beads, microspheres, particles, granules, wires, fibers or combinations thereof. If in particulate form, the particles may be spheroid, flat, irregular or elongated in shape. High aspect particulate fillers may be utilized, for example. Hollow as well as solid fillers are useful in the present invention. According to various embodiments of the invention, the filler may have an aspect ratio (i.e., the ratio of the length of an individual filler element, such as a particle or fiber, to the width of that individual filler element) of 1:1 or higher, e.g., greater than 1:1, at least 2:1, at least 3:1, at least 5:1, at least 10:1, at least 100:1, at least 1000:1; at least 10,000:1, at least 100,000:1, at least 500,000:1, at least 1,000,000:1 or even higher (i.e., effectively an infinite aspect ratio). According to other embodiments, the filler may have an aspect ratio not more than 2:1, not more than 3:1, not more than 5:1, not more than 10:1, not more than 100:1, not more than 1000:1; not more than 10,000:1, not more than 100,000:1, not more 500,000:1, or not more than 1,000,000:1

The surface of the filler may be modified in accordance with any of the methods or techniques known in the art. Such surface treatment methods include, without limitation, sizing (e.g., coating with one or more organic substances), silylation, oxidation, functionalization, neutralization, acidication, other chemical modifications and the like and combinations thereof.

The chemical nature of the filler may be varied and selected as may be desired in order to impart certain properties or characteristics to the product obtained upon curing the light-curable composition. For example, the filler may be inorganic or organic in character. Mixed organic/inorganic fillers may also be used. Carbon-based fillers (e.g., carbon fibers, carbon black, carbon nanotubes) as well as mineral fillers can be employed. One or more fibrous fillers (i.e., fillers in the form of fibers) may be utilized in especially preferred embodiments of the invention. Suitable exemplary fibrous fillers include carbon fibers (sometimes referred to as graphite fibers), glass fibers, silicon carbide fillers, boron fibers, alumina fibers, polymeric fibers (e.g., aramide fibers), metal fibers, natural fibers (such as fibers derived from plant sources) and combinations thereof. The fiber may be of natural or synthetic origin. Any of the following types of fiber can be used: short fibers (<10 mm in length), chopped fibers, long fibers (at least 10 mm in length), continuous fibers, woven continuous fibers, nonwoven continuous fibers, mats of woven fibers, mats of nonwoven fibers (e.g.,

random fiber mats), biaxial mats, unidirectional mats, continuous strands, unidirectional fibers, fiber tows, fiber fabrics, braided fibers, knitted fibers and the like and combinations thereof. Typically, suitable fibers will have a diameter of from about 2 to about 20 microns, e.g., from about 5 to about 10 microns. Hollow as well as solid fibers can be used; the fibers may be circular or irregular in cross-section.

Examples of other types of fillers which may be used in the curable compositions of the present invention include clays (including organically modified clays and nanoclays), bentonite, silicates (e.g., magnesium silicates, talc, calcium silicates, wollastonite), metal oxides (e.g., zinc oxide, titanium dioxide, alumina), carbonates (e.g., calcium carbonate), mica, zeolites, talc, sulfates (e.g., calcium sulfate), and the like and combinations thereof.

In one embodiment, the curable composition comprises a relatively high loading of one or more fillers that are not opaque but which are capable of scattering rays of light to which the light-curable composition is exposed. For example, light scattering may occur where the refractive index of the filler is dissimilar to the refractive index of the portion of the curable composition which does not include the filler (which typically, prior to curing, is a liquid comprised of light-curable compounds, the photoinitiator system and possibly other non-filler additives). Such fillers may include, for example, glass fillers (e.g., glass fibers) and fillers comprised of transparent polymers. In such an embodiment, the curable composition may comprise at least 20%, at least 30% or at least 40% by weight, based on the total weight of the curable composition, of such light-scattering filler(s).

Advantageously, the curable compositions of the present invention may be formulated to be solvent-free, i.e., free of any non-reactive volatile substances. However, in certain other embodiments of the invention, the curable composition may contain one or more solvents, in particular one or more organic solvents, which may be non-reactive organic solvents. In various embodiments, the solvent(s) may be relatively volatile, e.g., solvents having a boiling point at atmospheric pressure of not more than 150° C. In other embodiments, the solvent(s) may have a boiling point at atmospheric pressure of at least 40°C.

The solvent(s) may be selected so as to be capable of solubilizing one or more components of the curable composition and/or adjusting the viscosity or other rheological properties of the curable composition.

However, the curable compositions of the present invention may alternatively be formulated so as to contain little or no non-reactive solvent, e.g., less than 10% or less than 5% or even 0% non-reactive solvent, based on the total weight of the curable composition. Such solvent-less or low-solvent compositions may be formulated using various components, including for example low viscosity reactive diluents, which are selected so as to render the curable composition sufficiently low in viscosity, even without solvent being present, that the curable composition can be easily applied at a suitable application temperature to a substrate surface so as to form a relatively thin, uniform layer.

Suitable solvents may include, for example, organic solvents such as: ketones; esters; carbonates; alcohols; aromatic solvents such as xylene, benzene, toluene, and ethylbenzene; alkanes; glycol ethers; ethers; amides; as well as combinations thereof.

In various embodiments of the invention, the curable compositions described herein are formulated to have a viscosity of less than 10,000 cPs, or less than 9000 cPs, or less than 8000 cPs, or less than 7000 cPs, or less than 6000 cPs, or less than 5000 cPs, or less than 4000 cPs, or less than 3000 cPs, or less than 2500 cPs, or less than 2000 cPs, or less than 1500 cPs, or less than 1000 cPs or even less than 500 cPs as measured at 25°C using a Brookfield viscometer, model DV-II, using a 27 spindle (with the spindle speed varying typically between 20 and 200 rpm, depending on viscosity). In advantageous embodiments of the invention, the viscosity of the curable composition is from 200 to 1000 cPs at 25°C.

The curable compositions of the present invention may optionally contain one or more additives instead of or in addition to the above-mentioned ingredients. Such additives include, but are not limited to, antioxidants, ultraviolet absorbers, light blockers, photostabilizers, foam inhibitors, flow or leveling agents, colorants, pigments, dispersants (wetting agents), slip additives, plasticizers, thixotropic agents, matting agents, impact modifiers, thermoplastics such as acrylic resins that do not contain any free radical-polymerizable functional groups, waxes or other various additives, including any of the additives conventionally utilized in the coating, sealant, adhesive, molding, 3D printing or ink arts.

Uses of the Curable Compositions

The inventive curable compositions described herein may be compositions that are to be subjected to curing by means of free radical polymerization or other types of polymerization (e.g., cationic polymerization). End use applications for the inventive curable compositions include, but are not limited to, inks, coatings, adhesives, 3D printing resins, molding resins, sealants, composites and the like.

According to certain embodiments, the curable compositions may be formulated such that they are fully curable at ambient or room temperature. In other embodiments, however, the curable compositions are formulated such that partial curing takes place at ambient or room temperature, with further curing being accomplished by heating the partially cured composition to an elevated temperature. For example, the initial curing may be carried out by exposing the curable composition to an amount of radiation (e.g., ultraviolet light) effective to react (at least in part) the components of the

curable composition containing polymerizable ethylenically unsaturated functional groups, with further curing being effected by heating the curable composition to a temperature effective to initiate reaction of the components of the curable composition containing polymerizable heterocyclic-containing moieties. In such instances, curing may be considered to involve two stages: a first curing stage involving radiation (e.g., photo) curing and a second stage involving thermal curing.

Cured compositions prepared from curable compositions as described herein may be used, for example, in three-dimensional articles (wherein the three-dimensional article may consist essentially of or consist of the cured composition), coated articles (wherein a substrate is coated with one or more layers of the cured composition), laminated or adhered articles (wherein a first component of the article is laminated or adhered to a second component by means of the cured composition), composite articles or printed articles (wherein graphics or the like are imprinted on a substrate, such as a paper, plastic or M-containing substrate, using the cured composition).

Curing of compositions in accordance with the present invention may be carried out by any suitable method, such as free radical and/or cationic polymerization. One or more initiators, such as a free radical initiator (e.g., photoinitiator, peroxide initiator) may be present in the curable composition. Prior to curing, the curable composition may be applied to a substrate surface in any known conventional manner, for example, by spraying, knife coating, roller coating, casting, drum coating, dipping, jetting, extrusion, gel deposition, and the like and combinations thereof. Indirect application using a transfer process may also be used. A substrate may be any commercially relevant substrate, such as a high surface energy substrate or a low surface energy substrate, such as a metal substrate or plastic substrate, respectively. The substrates may comprise metal, paper, cardboard, glass, thermoplastics such as polyolefins, polycarbonate, acrylonitrile butadiene styrene (ABS), and blends thereof, composites, wood, leather and combinations thereof. When used as an adhesive, the curable composition may be placed between two substrates and then cured, the cured composition thereby bonding the substrates together to provide an adhered article.

Curing may be accelerated or facilitated by supplying energy to the curable composition, such as by heating the curable composition and/or by exposing the curable composition to a radiation source, such as visible or UV light, infrared radiation, and/or electron beam radiation. Thus, the cured composition may be deemed the reaction product of the curable composition, formed by curing.

A plurality of layers of a curable composition in accordance with the present invention may be applied to a substrate surface; the plurality of layers may be simultaneously cured (by exposure to a single dose of radiation, for example) or each layer may be successively cured before application of an additional layer of the curable composition.

The inventive curable compositions described herein are especially useful as 3D printing resin formulations, that is, compositions intended for use in manufacturing three dimensional articles using 3D printing techniques. Such three dimensional articles may be free-standing/self-supporting and may consist essentially of or consist of a composition in accordance with the present invention that has been cured. The three-dimensional article may also be a composite, comprising at least one component consisting essentially of or consisting of a cured composition as previously mentioned as well as at least one additional component comprised of one or more materials other than such a cured composition (for example, a metal component or a thermoplastic component). The curable compositions of the present invention are useful in digital light printing (DLP), although other types of three dimensional (3D) printing methods may also be practiced using the inventive curable compositions. Non-limiting examples of suitable 3D printing processes include stereolithography (SLA); digital light process (DLP); liquid crystal device (LCD); inkjet head (or multjet) printing; Continuous Liquid Interface Production (CLIP); extrusion type processes such as continuous fiber 3D printing and cast-in-motion 3D printing; and volumetric 3D printing. The building method may be "layer by layer" or continuous. The liquid may be in a vat, or deposited with an inkjet or gel deposition, for example.

A method of making a three-dimensional article using a curable composition in accordance with the present invention may comprise the steps of:

a) coating a first layer of any embodiment of the curable composition described herein in liquid form onto a surface;
b) exposing the first layer imagewise to actinic radiation to form a first exposed imaged cross-section, wherein the radiation is of sufficient intensity and duration to cause at least partial curing of the first layer in the exposed area(s);
c) coating an additional layer of the curable composition in liquid form onto the previously exposed imaged cross-section;
d) exposing the additional layer imagewise to actinic radiation to form an additional imaged cross-section, wherein the radiation is of sufficient intensity and duration to cause at least partial curing of the additional layer in the exposed area(s) and to cause adhesion of the additional layer to the previously exposed imaged cross-section;
e) repeating steps c) and d) a desired number of times to build up the three-dimensional article.

Although the photocuring steps may be carried out by any suitable means, which will in some cases be dependent upon the components present in the curable composition, in certain embodiments of the invention the photocuring is accomplished by exposing the layer to be cured to an effective amount of radiation (e.g., electron beam radiation, UV

radiation, visible light, etc.). The three-dimensional article which is formed may be heated in order to effect thermal curing.

Accordingly, in various embodiments, the present invention provides a process comprising the steps of:

a) coating a first layer of any embodiment of the curable composition described herein in liquid form onto a surface;
b) exposing the first layer imagewise to actinic radiation to form a first exposed imaged cross-section, wherein the radiation is of sufficient intensity and duration to cause at least partial curing (e.g., at least 50% curing, as measured by the % conversion of the (meth)acrylate double bonds initially present in the composition) of the layer in the exposed areas;
c) coating an additional layer of the curable composition onto the previously exposed imaged cross-section;
d) exposing the additional layer imagewise to actinic radiation to form an additional imaged cross-section, wherein the radiation is of sufficient intensity and duration to cause at least partial curing (e.g., at least 50% curing, as measured by the % conversion of the (meth)acrylate double bonds initially present in the composition) of the additional layer in the exposed areas and to cause adhesion of the additional layer to the previously exposed imaged cross-section;
e) repeating steps c) and d) a desired number of times to build up the three-dimensional article.

The process may comprise a further step f) comprising heating the three-dimensional article to a temperature effective to thermally cure the curable composition (i.e., to react the polymerizable oxetane and epoxy moiety-containing compounds present in the curable composition).

Within this specification, embodiments have been described in a way which enables a clear and concise specification to be written, but it is intended and will be appreciated that embodiments may be variously combined or separated without departing from the invention. For example, it will be appreciated that all preferred features described herein are applicable to all aspects of the invention described herein.

In some embodiments, the invention herein can be construed as excluding any element or process step that does not materially affect the basic and novel characteristics of the curable composition or process using the curable composition. Additionally, in some embodiments, the invention can be construed as excluding any element or process step not specified herein.

Although the invention is illustrated and described herein with reference to specific embodiments, the invention is not intended to be limited to the details shown. Rather, various modifications may be made in the details within the scope and range of equivalents of the claims and without departing from the invention.

EXAMPLES

The following materials were used in the Examples as shown in Table 1.

| Table 1: Components for Examples. | | |
|---|---|---|
| Material | Composition | Supplier |
| SR259; Acrylate compound | 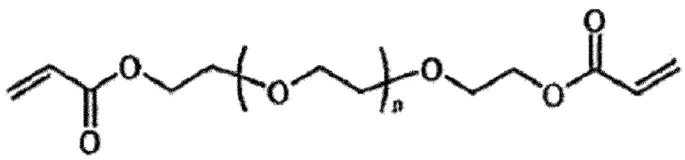 Poly(oxy-1,2-ethanediyl), α-1,6-hexanediylbis(ω-((1-oxo-2-propenyl)oxy); n=4 | Sartomer |
| Uvicure S105; Epoxy compound | 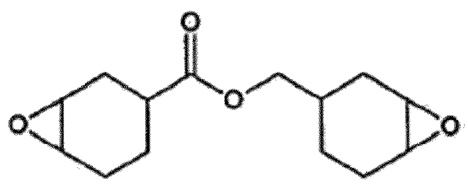 3,4-Epoxycyclohexylmethyl 3,4-epoxycyclohexanecarboxylate | Sartomer-Lambson |

(continued)

| Material | Composition | Supplier |
|---|---|---|
| UviCure S130 (OXT); Oxetane compound | 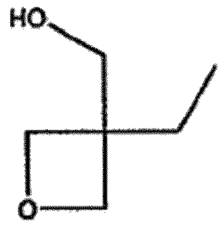<br>3-Ethyl-3-hydroxymethyl-oxetane | Sartomer-Lambson |
| SpeedCure BKL; Initiator | 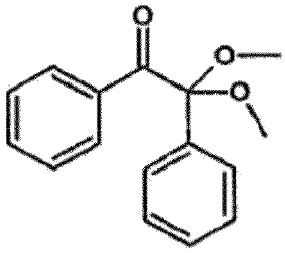<br>2,2-dimethoxy-1,2-diphenylethan-1-one | Sartomer-Lambson |
| SpeedCure 938; Initiator | 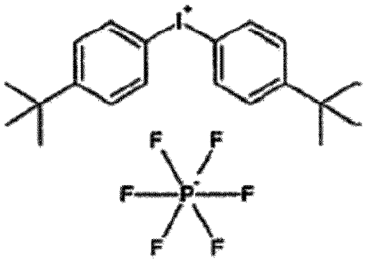<br>Bis (4-tert-butylphenyl) iodonium hexafluorophosphate | Sartomer-Lambson |
| SpeedCure ITX; Initiator | 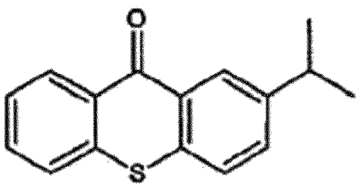<br>2-isopropyl-9H-thioxanthen-9-one | Sartomer-Lambson |
| UviCure S140; Oxetane compound | 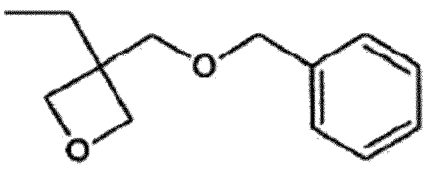<br>3-Ethyl-3-[(phenylmethoxy)methyl]-oxetane | Sartomer-Lambson |
| OXT-221 (DOX); Oxetane compound | 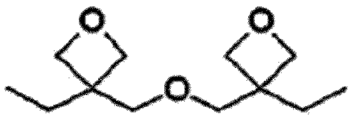<br>Bis[1-Ethyl(3-oxetanyl)]methyl ether | Toagosei |

(continued)

| Material | Composition | Supplier |
|---|---|---|
| UviCure S150 | 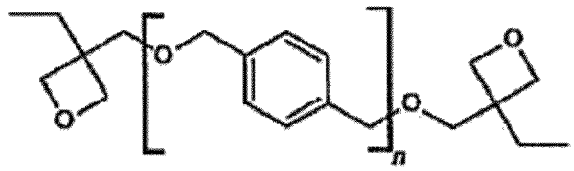 **n=1,2,3** 1,4-Bis[(3-ethyl-3-oxetanylmethoxy)methyl]benzene | Sartomer-Lambson |
| UviCure S160 | 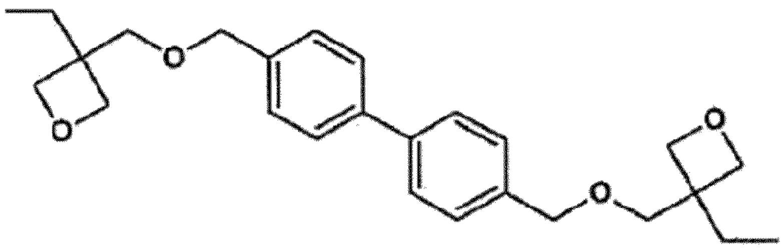 4,4-Bis(3-ethyl-3-oxetanyl)methoxymethyl]biphenyl | Sartomer-Lambson |
| UviCure S170 | 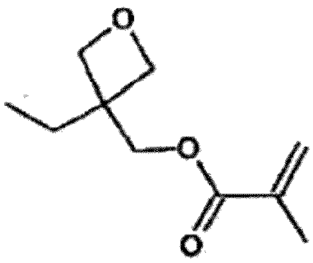 3-Ethyl-3-(Methacryloyloxy)Methyloxetane | Sartomer-Lambson |

Sample Preparation Procedure

Formulation preparation in Table 1 and Table 2:
In a 125 mL brown amber glass bottles, SR259, Uvicure S105 and the various oxetanes were loaded at first, SpeedCure ITX, 938 and BKL were charged next. The 100g mixture of each sample was sealed in bottle by securing lid with white tape. Then, three glass bottles were placed on roller in 65°C oven for about 2h until the solution became clear. For the Uvicure S150 and S160 samples, due to their high viscosity, the 100g mixture was made in a 250mL metal can by using a mechanical mixer and heating up to 45°C for about 2 hours until the solution became clear.

Printing thin strip sample using 355nm SLA Viper™ photopolymeric additive layer manufacturing system.

a. Cut the PET (polyethylene terephthalate) film into a square (approximate size of 7.5" X 6.5") which fits the shape of the glass (8" X 8") and attached the PET film to the glass using double-sided tape.

b. Sprayed non-sticky substances (Rust-o-leum Never Wet Coat 1 Spray) onto the PET film evenly.

c. Selected the "elevator motion" of SLA Viper to set the elevator position as 3.3717.

d. Used the pipette to draw around 2mL liquid onto the glass.

e. Used 5μm side of coating applicator to apply the first layer of film.

f. Set up a moderate (3~5 mJ/cm$^2$) laser exposure (Ec) and penetration depth (Dp) (20~70 mils) in order to obtain good green strength of film, and started printing.

g. Once the first layer of printing completed, used the 10μm side of applicator to apply the second 5um of layer of film.

h. Repeated printing and applying thin film until the 30μm side had been used.

i. Thus, a 6 layer, 5 μm each layer, three 4" X 0.5" green thin tensile strips and one 35mm X 12mm DMA strip were printed per print.

j. Drained off uncured liquid resin, cleaned with isopropyl alcohol and dried in air.

k. Carefully peeled each thin strip from PET film.

l. Post-cured the thin strips for 15 minutes at 30°C with 100% intensity (EnvisionTEC PCA 2000 curing unit).

m. Stored the samples at 23 ± 2 °C and 50 ± 10% relative humidity conditions for at least 7 days before testing.

Test methods:

LED-DSC Test

A photo differential scanning calorimetry (DSC) with a customized 365nm LED lamp setup was used for the testing. All photopolymerization rate measurements were performed using a Q2000 DSC unit from TA Instruments. A lamp holder for the DSC unit can be customized and printed from Arkema N3xtDimension® engineered resin N3D-TOUGH784 in order to ensure precise fit of a 365nm lamp Accucure ULM-2-365 or a 405nm lamp Accucure ULM-2-405 from Digital Light Labs. The LED light was automatically triggered by connecting the "Event" outlet of the DSC unit to an Accure Photo Rheometer Ultraviolet Illumination & Measurement System. LED light exposure can be programed by using "Event" on or off from Photo DSC software, but the intensity of light can be preset from the Accure Photo Rheometer Ultraviolet Illumination & Measurement System. For measurement, an approximately 5 mg liquid sample was placed at the center of a T130522 DSC Tzero pan, cured by exposing it to 50mW/cm$^2$ of 365nm or 405nm LED light for 5 minutes under a 50 mL/min $N_2$ flow rate and 40°C, followed by a second exposure under the same condition in order to determine and deduct the blank. The resulting heat flow (W/g) curve was collected to analyze maximum heat flow peak value and maximum peak time.

Real-time FTIR (Fourier Transform Infrared Spectroscopy)

A Real Time Fourier Transform Infrared (RT-FTIR) with an Attenuated Total Reflection (ATR) setup was used. All polymerization rate measurements were performed using Nicolet iS50 FT-IR Spectrometer from Thermo Scientific, equipped with a standard DLaTGS detector. A lamp holder for the ART platform of FTIR unit can be customized and printed from Arkema N3xtDimension® engineered resin N3D-TOUGH784 in order to ensure precisely fit of a 365nm lamp Accucure ULM-2-365 or a 405nm lamp Accucure ULM-2-405 from Digital Light Labs. The LED light was manually triggered by Ultraviolet illumination & Measurement System. LED light exposure can be programed by AccuCure software. For measurement, a drop of liquid sample was placed in the center of an ATR crystal. 3 mil of thin film was coated by a customized coating applicator (3mil WFM, G1046 from BYK). The LED lamp with holder was place on the top of ART platform. Then the real time FTIR scan was initiated to collect IR spectrum. Once the liquid spectrum was collected, the 50mW/cm$^2$ intensity of LED light source was turned on to start photopolymerization for a total of 200 seconds. Since the ring opening of both epoxide and oxetane generated C-O-C bond, the growth of C-O-C IR peak height at ~1100 cm$^{-1}$ was monitored while a C=O reference peak height at ~1727 cm$^{-1}$ were collected as well. The resulting of peak height ratio 1100cm$^{-1}$/1727cm$^{-1}$ at 20s was calculated to assess cationic cure speed.

Dynamic Mechanical Analyzer (DMA) testing

The DMA testing was performed with a TA Instruments DMA Q800 to determine changes in mechanical properties in each cured DMA strip throughout a temperature range . The DMA instrument was operated from -150 °C to 250 °C at 3 °C/min with a frequency of 1Hz. The storage modulus (G'), loss modulus (G") and tan(delta) curves are measured over the temperature range.

Tensile testing

An Instron 5966 with load capacity of 10kN with tensile testing fixtures was used to measure tensile properties.

The thin strips were prepared for tensile properties. Six specimens were prepared for each sample, and the test speeds for tensile tests were set to 5 mm/min. The tests were conducted following the ASTM D882-10 protocol.

Examples and Performance

Table 2 tabulates the formulations, cure rates and mechanical properties of the cured compositions in formulations including 10% by weight of acrylate based on the total weight of the composition. The components of each formulation are set out in Table 1 (amounts are indicated in % by weight based on the total weight of the composition). The ratio Oxetane/(Oxetane + Epoxy) is expressed as a % by weight of oxetane based on the total weight of oxetane and epoxy.

Table 2. Various ratios of Oxetane/(Oxetane + Epoxy) in a hybrid system

| Table 2. Various ratios of Oxetane/(Oxetane + Epoxy) in a hybrid system | | | | | | | |
|---|---|---|---|---|---|---|---|
| Component | Comp Ex. 1 | Comp Ex. 2 | Comp Ex. 3 | Ex. 1 | Ex. 2 | Ex. 3 | Comp. Ex. 4 |
| SR259 | 10 | 10 | 10 | 10 | 10 | 10 | 10 |
| Uvicure S105 | 83.8 | 67 | 50.28 | 33.52 | 16.76 | 8.38 | 0 |
| Uvicure S130 | 0 | 16.8 | 33.52 | 50.28 | 67.04 | 75.42 | 83.8 |
| SpeedCure BKL | 2 | 2 | 2 | 2 | 2 | 2 | 2 |
| SpeedCure 938 | 4 | 4 | 4 | 4 | 4 | 4 | 4 |
| SpeedCure ITX | 0.2 | 0.2 | 0.2 | 0.2 | 0.2 | 0.2 | 0.2 |
| Total | 100 | 100 | 100 | 100 | 100 | 100 | 100 |
| Oxetane Oxetane + Epoxy (% by weight) | 0 | 20 | 40 | 60 | 80 | 90 | 100 |
| Max heat flow* (W/g) (405nm) | 9.07 | 31.60 | 56.93 | 86.20 | 100.70 | 54.96 | 11.77 |
| Peak time (mins)‡* (405nm) | 0.07 | 0.04 | 0.03 | 0.02 | 0.02 | 0.03 | 0.23 |
| Max heat flow* (W/g) (365nm) | 12.76 | 35.20 | 58.44 | 89.04 | 92.16 | 35.54 | 19.37 |
| Peak time (mins)‡ (365nm) | 0.05 | 0.04 | 0.02 | 0.02 | 0.02 | 0.03 | 0.15 |
| Peak height ratio* (1100/1727cm$^{-1}$) (405nm, 20s) | 0.24 | 0.77 | 1.35 | 2.38 | 3.12 | 2.62 | 0 |
| Peak height ratio* (1100/1727cm-1) (365nm, 20s) | 0.41 | 0.93 | 1.50 | 2.38 | 3.37 | 2.74 | 0.26 |
| *higher is better; ‡lower is better | | | | | | | |

Table 3 tabulates the formulations, cure rates and mechanical properties of the cured compositions in formulations including 65% by weight of acrylate based on the total weight of the composition. The components of each formulation are set out in Table 1 (amounts are indicated in % by weight based on the total weight of the composition). The ratio Oxetane/(Oxetane + Epoxy) is expressed as a % by weight of oxetane based on the total weight of oxetane and epoxy.

| Table 3. Various ratios of Oxetane/(Oxetane + Epoxy) in a high acrylate hybrid system | | | | | | | |
|---|---|---|---|---|---|---|---|
| Component | Comp Ex. 5 | Comp Ex. 6 | Comp Ex. 7 | Ex. 4 | Ex. 5 | Ex. 6 | Comp. Ex. 8 |
| SR259 | 65 | 65 | 65 | 65 | 65 | 65 | 65 |
| Uvicure S105 | 29.4 | 23.52 | 17.64 | 11.74 | 5.88 | 2.94 | 0 |
| Uvicure S130 | 0 | 5.88 | 11.76 | 17.64 | 23.52 | 26.4 | 29.4 |
| SpeedCure BKL | 4 | 4 | 4 | 4 | 4 | 4 | 4 |

(continued)

| Component | Comp Ex. 5 | Comp Ex. 6 | Comp Ex. 7 | Ex. 4 | Ex. 5 | Ex. 6 | Comp. Ex. 8 |
|---|---|---|---|---|---|---|---|
| SpeedCure 938 | 1.4 | 1.4 | 1.4 | 1.4 | 1.4 | 1.4 | 1.4 |
| SpeedCure ITX | 0.2 | 0.2 | 0.2 | 0.2 | 0.2 | 0.2 | 0.2 |
| Total | 100 | 100 | 100 | 100 | 100 | 100 | 100 |
| Oxetane Oxetane + Epoxy (% by weight) | 0 | 20 | 40 | 60 | 80 | 90 | 100 |
| Max heat flow* (W/g) (405nm) | 29.34 | 36.82 | 46.45 | 51.14 | 55.31 | 43.37 | 35.09 |
| Peak time (mins)‡* (405nm) | 0.08 | 0.08 | 0.05 | 0.05 | 0.05 | 0.05 | 0.06 |
| Max heat flow* (W/g) (365nm) | 44.17 | 44.39 | 56.20 | 56.54 | 62.27 | 50.23 | 39.46 |
| Peak time (mins)‡ (365nm) | 0.02 | 0.03 | 0.03 | 0.03 | 0.02 | 0.03 | 0.03 |
| Peak height ratio* (1100/1727cm$^{-1}$) (405nm, 20s) | 0.10 | 0.30 | 0.38 | 0.42 | 0.40 | 0.29 | 0.28 |

The results shown in Tables 2 and 3 highlight the surprising results that when the oxetane component represents around 80% of the total weight of the epoxy and oxetane components in the composition, the cure rate was at a maximum, as shown by the high peak height ratio and the low peak time at that composition.

Tables 4 and 5 show the difference between 20% and 80% by weight of oxetane based on the total weight of epoxy and oxetane in the composition. The components of each formulation are set out in Table 1 (amounts are indicated in % by weight based on the total weight of the composition). The ratio Oxetane/(Oxetane + Epoxy) is expressed as a % by weight of oxetane based on the total weight of oxetane and epoxy.

| Table 4: 20 wt% vs 80 wt% of Oxetane/(Oxetane + Epoxy) in a low acrylate hybrid system | | | | | | |
|---|---|---|---|---|---|---|
| Component | Comp Ex 2 | Ex 2 | Comp Ex 9 | Ex 9 | Comp Ex 10 | Ex 10 |
| SR259 | 10 | 10 | 10 | 10 | 10 | 10 |
| Uvicure S105 | 67 | 16.76 | 67 | 16.76 | 67 | 16.76 |
| Uvicure S130 | 16.8 | 67.04 | | | | |
| Uvicure S140 | | | 16.8 | 67.04 | | |
| Uvicure S150 | | | | | 16.8 | 67.04 |
| SpeedCure BKL | 2 | 2 | 2 | 2 | 2 | 2 |
| SpeedCure 938 | 4 | 4 | 4 | 4 | 4 | 4 |
| SpeedCure ITX | 0.2 | 0.2 | 0.2 | 0.2 | 0.2 | 0.2 |
| Total | 100 | 100 | 100 | 100 | 100 | 100 |
| Oxetane Oxetane + Epoxy (% by weight) | 20 | 80 | 20 | 80 | 20 | 80 |
| Eq. weight | 116 | | 206 | | 167 | |
| Oxetane viscosity (25°C, mPas) | 22.4 | | 8.1 | | 130~170 | |
| Max heat flow (W/g) (365nm) | 35.20 | 92.16 | 19.22 | 35.52 | 16.57 | 37.97 |
| Peak time (mins) (365nm) | 0.04 | 0.02 | 0.03 | 0.03 | 0.04 | 0.03 |
| Peak height ratio (1100/1727cm$^{-1}$) (365nm) | 0.93 | 3.73 | 0.52 | 1.95 | 0.47 | 1.51 |
| Tensile strength (MPa) | 41.26 | 1.59 | 14.53 | 0.33 | 25.15 | 36.37 |
| Tensile modulus (MPa) | 1840.7 | 7.1 | 787.0 | 0.9 | 1529.6 | 1605.2 |
| Elongation at break (%) | 3.91 | 60.13 | 8.84 | 42.21 | 2.58 | 2.93 |

(continued)

| Component | Comp Ex 2 | Ex 2 | Comp Ex 9 | Ex 9 | Comp Ex 10 | Ex 10 |
|---|---|---|---|---|---|---|
| Energy at break (J) | 0.447 | 0.177 | 0.45 | 0.03 | 0.17 | 0.25 |
| Tg (Tan Delta, °C) | 80.2 | 29.8 | 76.9 | 15.4 | 73.9 | 65.0 |

| Table 5: 20 wt% vs 80 wt% of Oxetane/(Oxetane + Epoxy) in a low acrylate hybrid system | | | | | | |
|---|---|---|---|---|---|---|
| Component | Comp Ex 11 | Ex 11 | Comp Ex 12 | Ex 12 | Comp Ex 13 | Ex 13 |
| SR259 | 10 | 10 | 10 | 10 | 10 | 10 |
| Uvicure S105 | 67 | 16.76 | 67 | 16.76 | 67 | 16.76 |
| Uvicure S130 | | | | | | |
| Uvicure S140 | | | | | | |
| Uvicure S150 | | | | | | |
| Uvicure S160 | 16.8 | 67.04 | | | | |
| Uvicure S170 | | | 16.8 | 67.04 | | |
| DOX (221) | | | | | 16.8 | 67.04 |
| SpeedCure BKL | 2 | 2 | 2 | 2 | 2 | 2 |
| SpeedCure 938 | 4 | 4 | 4 | 4 | 4 | 4 |
| SpeedCure ITX | 0.2 | 0.2 | 0.2 | 0.2 | 0.2 | 0.2 |
| Total | 100 | 100 | 100 | 100 | 100 | 100 |
| $\frac{\text{Oxetane}}{\text{Oxetane+Epoxy}}$ (% by weight) | 20 | 80 | 20 | 80 | 20 | 80 |
| Eq. weight | 205 | | 184 | | 107 | |
| Oxetane viscosity (25°C, mPas) | 250 (50°C) | | 2-10 | | 12.8 | |
| Max heat flow (W/g) (365nm) | 15.20 | 24.35 | 9.10 | 9.38 | 21.10 | 47.45 |
| Peak time (mins) (365nm) | 0.04 | 0.04 | 7.42 | 26.62 | 2.22 | 2.02 |
| Peak height ratio (1100/1727cm$^{-1}$) (365nm) | 0.45 | 1.16 | 0.37 | 0.46 | 0.71 | 3.11 |
| Tensile strength (MPa) | 18.79 | 41.98 | 14.83 | 16.3 | 23.97 | 26.65 |
| Tensile modulus (MPa) | 1283.8 | 1939.2 | 1700.1 | 1196.7 | 1197.6 | 1551.2 |
| Elongation at break (%) | 1.94 | 2.75 | 0.98 | 2.77 | 3.56 | 2.07 |
| Energy at break (J) | 0.12 | 0.24 | 0.03 | 0.04 | 0.25 | 0.12 |
| Tg (Tan Delta, °C) | 99.3 | 68.3 | 82.8 | 87.0 | 80.4 | 88.3 |

## Claims

**1.** An actinic radiation curable composition comprising:

a) one or more oxetane functional compounds;
b) one or more epoxy functional compounds;
c) one or more (meth)acrylate functional compounds;
d) at least one photoinitiator;

wherein the composition comprises from 55% to 90%, preferably from 60% to 90%, more preferably from 70% to 90%, by weight of the one or more oxetane functional compounds based on the total weight of the one or more oxetane functional compounds and the one or more epoxy functional compounds in the composition; and
optionally at least one additive.

2. The actinic radiation curable composition of claim 1, wherein the composition comprises from 5% to 95%, preferably from 8% to 90%, more preferably from 10% to 80%, by weight of the one or more (meth)acrylate functional compounds based on the total weight of the composition.

3. The actinic radiation curable composition of claim 1 or 2, wherein the composition comprises from 75% to 85% by weight of the one or more oxetane functional compounds based on the total weight of the one or more oxetane functional compounds and the one or more epoxy functional compounds in the composition.

4. The actinic radiation curable composition of any one of claims 1 to 3, wherein the one or more oxetane functional compounds comprise at least one of a monofunctional oxetane compound or a difunctional oxetane compound.

5. The actinic radiation curable composition of any one of claims 1 to 4, wherein the one or more epoxy functional compounds comprise at least one of a monofunctional epoxy compound or a difunctional epoxy compound.

6. The actinic radiation curable composition of any one of claims 1 to 5, wherein the one or more oxetane functional compounds comprise at least one of 3-ethyl-3-hydroxymethyl-oxetane, 3-ethyl-3-[(phenylmethoxy)methyl]-oxetane, bis[1-ethyl(3-oxetanyl)]methyl ether, 1,4-bis[(3-ethyl-3-oxetanylmethoxy)methyl]benzene, 4,4-bis(3-ethyl-3-oxetanyl)methoxymethyl]biphenyl, 3-ethyl-3-(methacryloyloxy)methyloxetane, trimethylolpropane tris(3-ethyl-3-oxetanylmethyl)ether, or combinations thereof.

7. The actinic radiation curable composition of any one of claims 1 to 6, wherein the one or more epoxy functional compounds comprise at least one of epoxidized vegetable oils, mono-epoxides, di-epoxides, poly-epoxides, alicyclic polyglycidyl compounds, cycloaliphatic polyepoxides, epoxy ethers, aromatic epoxies, aliphatic epoxies, aliphatic glycidyl ethers, linear, branched epoxidized polyenes, or combinations thereof.

8. The actinic radiation curable composition of any one of claims 1 to 7, wherein the one or more epoxy functional compounds comprise at least one of 3,4-epoxycyclohexylmethyl 3,4-epoxycyclohexanecarboxylate, bis(3,4-epoxycyclohexyl)adipate, 3,4-epoxycyclohexylmethyl 3,4-epoxycyclohexanecarboxylate modified caprolactone, or combinations thereof.

9. The actinic radiation curable composition of any one of claims 1 to 8, wherein the epoxide compound and/or the oxetane compound comprises one or more (meth)acrylate functional epoxides, one or more (meth)acrylate functional oxetanes, one or more epoxy functional oxetanes, or a combination thereof.

10. The actinic radiation curable composition of any one of claims 1 to 9, wherein the composition further comprises one or more one thermal initiators.

11. The actinic radiation curable composition of any one of claims 1 to 10, further comprising one or more hydroxyl functional compounds.

12. The actinic radiation curable composition of any one of claims 1 to 11 further comprising at least one filler.

13. The actinic radiation curable composition of any one of claims 1 to 12, wherein the photoinitiator comprises at least one of a cationic photoinitiator or a free radical photoinitiator.

14. A method of making a cured material, wherein the method comprises actinic radiation curing the actinic radiation curable composition of any one of claims 1 to 13.

15. A method for the preparation of a 3D-printed article comprising the steps of:

a) providing a first layer of a actinic radiation curable composition of any one of claims 1 to 13 onto a surface;
b) curing the first layer, at least partially, to provide a cured first layer;

c) providing an second layer of the actinic radiation curable composition onto the first cured layer;
d) curing the second layer, at least partially, to provide a cured second layer adhered to the cured first layer;
e) repeating steps c) and d) a desired number of times to build up the 3D-printed article.

**16.** The method of claim 15, further comprising a step f) comprising heating the 3D-printed article to a temperature effective to thermally cure the curable composition.

European Patent Office / Europäisches Patentamt / Office européen des brevets

# EUROPEAN SEARCH REPORT

Application Number
EP 21 30 6962

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/044623 A1 (RUNDLETT BETH [US]) 12 February 2015 (2015-02-12) * page 16; example 3; table 2 * ----- | 1-16 | INV. G03F7/00 G03F7/027 |
| X | EP 0 848 294 A1 (DSM NV [NL]; JAPAN SYNTHETIC RUBBER CO LTD [JP] ET AL.) 17 June 1998 (1998-06-17) * page 16; examples 4, 5; table 1 * ----- | 1-16 | |
| A | WO 2008/110512 A1 (HUNTSMAN ADV MAT SWITZERLAND [CH]; MESSE LAURENCE [FR] ET AL.) 18 September 2008 (2008-09-18) * page 6, line 13 - page 7, line 5 * ----- | 1-16 | |
| A | US 2020/308426 A1 (JAMES DAVID [SE] ET AL) 1 October 2020 (2020-10-01) * paragraph [0049] * ----- | 1-16 | |

TECHNICAL FIELDS SEARCHED (IPC)

G03F

The present search report has been drawn up for all claims

1

| Place of search | Date of completion of the search | Examiner |
|---|---|---|
| Munich | 7 June 2022 | Le Masson, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 21 30 6962

This annex lists the patent family members relating to the patent documents cited in the above-mentioned European search report. The members are as contained in the European Patent Office EDP file on
The European Patent Office is in no way liable for these particulars which are merely given for the purpose of information.

07-06-2022

| Patent document cited in search report | Publication date | Patent family member(s) | Publication date |
|---|---|---|---|
| US 2015044623 A1 | 12-02-2015 | CN 104345562 A | 11-02-2015 |
| | | EP 2842980 A1 | 04-03-2015 |
| | | JP 6414411 B2 | 31-10-2018 |
| | | JP 2015036420 A | 23-02-2015 |
| | | US 2015044623 A1 | 12-02-2015 |
| EP 0848294 A1 | 17-06-1998 | DE 69706816 T2 | 25-04-2002 |
| | | EP 0848294 A1 | 17-06-1998 |
| | | JP 3765896 B2 | 12-04-2006 |
| | | JP H10168165 A | 23-06-1998 |
| | | US 5981616 A | 09-11-1999 |
| | | US 6365644 B1 | 02-04-2002 |
| | | US RE42593 E | 02-08-2011 |
| WO 2008110512 A1 | 18-09-2008 | CN 101631832 A | 20-01-2010 |
| | | EP 2118197 A1 | 18-11-2009 |
| | | JP 2010520947 A | 17-06-2010 |
| | | KR 20100014901 A | 11-02-2010 |
| | | US 2010119835 A1 | 13-05-2010 |
| | | WO 2008110512 A1 | 18-09-2008 |
| US 2020308426 A1 | 01-10-2020 | CN 111491776 A | 04-08-2020 |
| | | EP 3727797 A1 | 28-10-2020 |
| | | SE 1730346 A1 | 11-06-2019 |
| | | US 2020308426 A1 | 01-10-2020 |
| | | WO 2019125296 A1 | 27-06-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 7183040 B
- US 7696260 B
- US 9861452 B
- US 20100222512 A1
- US 3835003 A
- US 5750590 A
- US 5674922 A
- US 5981616 A
- US 6469108 B
- US 6015914 A
- US 8377623 B


### Non-patent literature cited in the description


- *J. Appl. Polym. Sci.,* 2020, vol. 137, 48333
- *Polym. Int.,* 2016, vol. 65, 1486-1492
- *J. Photopolym. Sct. Technol.,* 2000, vol. 13 (1), 119-124
- *J. Polym. Sci. Part A: Polym. Chem.,* 2005, vol. 43, 3205-3220
- *Polymer,* 2001, vol. 42, 5531-5541